# EUROPEAN PATENT APPLICATION

(11) **EP 4 832 723 A1**
(43) Date of publication of application: **28.10.2026**
(21) Application number: 25863852.7
(22) Date of filing: 03.02.2025
(51) Int. Cl.: H10K 59/80, B60K 35/22, B60J 3/04, H10K 59/50, G02F 1/165, G02F 1/00

(54) **DISPLAY APPARATUS**

(30) Priority: 04.09.2024 KR 20240120360
(71) Applicant: LG Electronics Inc., Yeongdeungpo-gu Seoul 07336 (KR)
(72) Inventor: SHIN, Jongyeon, Seoul 07796 (KR); PARK, Jayhee, Seoul 07796 (KR); LEE, Moungyoub, Seoul 07796 (KR); OH, Jaewon, Seoul 07796 (KR)
(74) Representative: Vossius & Partner Patentanwälte Rechtsanwälte mbB
(86) International application number: PCT/KR2025/001620
(87) International publication number: WO 2026/054202

(57) **Abstract**

A display apparatus according to the present embodiment comprises: a transparent display; a front glass facing the transparent display; a rear glass facing the front glass; and a sealing member between the front glass and the rear glass. An inner space in which at least one of a first fluid and a second fluid is accommodated may be formed between the front glass and the rear glass. The specific gravity of the first fluid may be different from the specific gravity of the second fluid. A first inlet/outlet portion through which the first fluid flows into the inner space or the first fluid in the inner space flows out may be formed in a portion of the sealing member. A second inlet/outlet portion through which the second fluid flows into the inner space or the second fluid in the inner space flows out may be formed in another portion of the sealing member.

## Description

### [Technical Field]

The present invention relates to a display device.

### [Background Art]

A display device is a device configured to display output information.

The display device may be installed in a vehicle and may provide various types of information to an occupant.

One example of the display device may be a transparent display device. U.S. Patent No. US 9,240,162 B2 (patented on Jan. 19, 2016) discloses a transparent display device (100) having adjustable transparency. The transparent display device includes a transparent display, a light source, an optical sensor configured to measure characteristics of light incident from the light source, and a light control unit configured to adjust transparency of the light according to the characteristics of the light, thereby maximizing visibility of an object displayed on the transparent display

U.S. Patent Application Publication No. US 2023/0228988 A1 (published on Jul. 20, 2023) discloses a system for controlling optical properties of light, the system comprises a cell including a first optically transparent member and a second optically transparent member arranged in a vertical direction; and at least two fluids, wherein the transparent members are arranged parallel to each other and spaced apart from each other by closed edges to define a space therebetween, the first fluid and the second fluid have at least one different optical property from each other, at least a portion of the first fluid is accommodated in the space, the second fluid is configured to be accommodated into the space, the first fluid and the second fluid remain separated while interfacing with each other in the space, when the second fluid is injected into the space, the first fluid is displaced, and when the second fluid is withdrawn from the space, the first fluid remains in the space.

### [Disclosure]

### [Technical Problem]

The present embodiment is directed to providing a display device in which a first fluid and a second fluid flow into or out of the display device through a sealing member, so that the number of components can be minimized and the structure can be simplified.

### [Technical Solution]

A display device according to the present embodiment may comprise a transparent display; a front glass facing the transparent display; a rear gla facing the front glass; and a sealing member disposed between the front glass and the rear glass.

An inner space configured to accommodate at least one of a first fluid and a second fluid may be formed the front glass and the rear glass.

A specific gravity of the first fluid may be different from a specific gravity of the second fluid.

A first inlet/outlet through which the first fluid flows into the inner space or through which the first fluid in the inner space flows out may be formed in a portion of the sealing member.

A second inlet/outlet through which the second fluid flows into the inner space or through which the second fluid in the inner space flows out may be formed in another portion of the sealing member.

The display device may further comprise a bezel configured to fix the front glass and the rear glass.

An area of the bezel may be greater than a projected area of the sealing member.

The display device may further comprise a curing agent formed on one side of the sealing member.

The front glass may comprise a first surface adjacent to the transparent display; and a second surface opposite to the first surface.

A front water-repellent layer may be formed on the second surface.

The rear glass may comprise a third surface adjacent to the second surface; and a fourth surface opposite to the third surface.

A rear water-repellent layer may be formed on the third surface.

The display device may further comprise a first reservoir configured to accommodate the first fluid; a second reservoir configured to accommodate the second fluid; a first fluid passage disposed between the first reservoir and the first inlet/outlet; and a second fluid passage disposed between the second reservoir and the second inlet/outlet.

The first fluid passage may be connected to each of the inner space and the first reservoir.

The second fluid passage may be connected to each of the inner space and the second reservoir.

A plurality of first fluid passages may be provided, and a plurality of first inlet/outlets may be provided to correspond to the plurality of first fluid passages,

A plurality of second fluid passages may be provided, and a plurality of second inlet/outlets may be provided to correspond to the plurality of second fluid passages.

The first fluid accommodated in the first reservoir may be branched into the plurality of first fluid passages and move into the inner space through the plurality of first fluid passages.

The second fluid accommodated in the second reservoir may be branched into the plurality of second fluid passages and move into the inner space through the plurality of second fluid passages.

A plurality of first reservoirs and a plurality of first fluid passages may be provided, and a plurality of second reservoirs and a plurality of second fluid passages may be provided.

Among the first fluid and the second fluid, a fluid having a higher specific gravity may flow into the inner space through a lower portion of the inner space or flow out through the lower portion of the inner space.

Among the first fluid and the second fluid, a fluid having a lower specific gravity may flow into the inner space through an upper portion of the inner space or flow out through the upper portion of the inner space.

When the first fluid accommodated in the first reservoir flows into the inner space through the first fluid passage and the first inlet/outlet, the second fluid accommodated in the inner space may move to the second reservoir through the second inlet/outlet and the second fluid passage.

At least one of the first reservoir and the second reservoir may be disposed below the transparent display.

The display device may comprise a variable reservoir configured to accommodate one of the first fluid and the second fluid and having a variable internal volume; and an actuator configured to pressurize the variable reservoir,

in response to operation of the actuator, the fluid in the variable reservoir may move into the inner space.

The display device may comprise a reservoir in which a first storage space configured to accommodate the first fluid and a second storage space configured to accommodate the second fluid are formed; and an actuator configured to increase one of the first storage space and the second storage space while decreasing the other of the first storage space and the second storage space.

The actuator may comprise a driving source; at least one power transmission member operated upon driving of the driving source; and a pressure plate configured to partition an interior of the reservoir into the first storage space and the second storage space and connected to the at least one power transmission member.

Volumes of the first storage space and the second storage space are varied in response to movement of the pressure plate.

When the volume of the first storage space decreases, the volume of the second storage space may increase.

When the volume of the first storage space increases, the volume of the second storage space may decrease.

The display device may comprise a first reservoir in which a first storage space configured to accommodate the first fluid is formed; and a second reservoir in which a second storage space configured to accommodate the second fluid is formed.

The first reservoir comprises a barrier configured to partition the first storage space into a first space configured to accommodate the first fluid and a second space configured to accommodate the first fluid.

The first fluid passage may comprise a low-pressure passage connected to each of the inner space and the first space; and a high-pressure passage connected to each of the inner space and the second space.

The display device may comprise a first reservoir configured to accommodate the first fluid; a second reservoir configured to accommodate the second fluid and spaced apart from the first reservoir; and a driving source disposed between the first reservoir and the second reservoir.

The first reservoir, the driving source, and the second reservoir may be arranged in a line.

Corresponding to a driving direction of the driving source, an inflow direction and an outflow direction of the first fluid and an inflow direction and an outflow direction of the second fluid may be simultaneously changed.

### [Advantageous Effect]

According to the present embodiment, the first fluid and the second fluid flow into the inner space between the front glass and the rear glass through the first inlet/outlet and the second inlet/outlet formed in the sealing member, or the first fluid and the second fluid in the inner space flow out through the first inlet/outlet and the second inlet/outlet formed in the sealing member, so that the first fluid and the second fluid can be controlled with a simple configuration.

Further, there is no need to dispose ports through which the first fluid or the second fluid passes in the front glass and the rear glass, the number of components can be minimized, and manufacturing is facilitated.

Further, when the first fluid having a higher specific gravity flows into a lower region of the inner space, the second fluid having a lower specific gravity can flow out through an upper region of the inner space.

Further, the bezel can fix the front glass and the rear glass while shielding the sealing member.

Further, the first fluid and the second fluid can rapidly flow by the front water-repellent layer and the rear water-repellent layer.

Further, upon compression or expansion of the variable reservoir, the first fluid or the second fluid accommodated in the variable reservoir can rapidly flow into the inner space.

Further, the first fluid and the second fluid can be simultaneously caused to flow by a single driving source.

Further, the first reservoir includes a barrier configured to partition the first storage space into a first space configured to accommodate the first fluid and a second space configured to accommodate the first fluid, so that the first fluid can be distributed and caused to flow into the light-shielding cell, an interface between the first fluid and the second fluid can be formed in a curved shape, and a premium appearance can be achieved.

Further, the first reservoir and the second reservoir are arranged in a line, thereby enabling a compact configuration.

Further, the first reservoir, the driving source, and the second reservoir are arranged in a line, so that an inflow direction and an outflow direction of the first fluid and the second fluid can be simultaneously changed according to a driving direction of the driving source.

### [Description of Drawings]

FIG. 1 illustrates a display device according to the present embodiment,
FIG. 2 illustrates various modes of the display device according to the present embodiment,
FIG. 3 is an exploded perspective view of the display device according to the present embodiment,
FIG. 4 is a schematic view illustrating an example of a light-shielding cell according to the present embodiment,
FIG. 5 illustrates a light-shielding cell and a reservoir according to the present embodiment,
FIG. 6 is a cross-sectional view taken along line A-A of FIG. 5,
FIG. 7 illustrates a modified example of the light-shielding cell and the reservoir according to the present embodiment,
FIG. 8 illustrates a second example of the display device according to the present embodiment,
FIG. 9 illustrates a third example of the display device according to the present embodiment,
FIG. 10 illustrates a fourth example of the display device according to the present embodiment,
FIG. 11 illustrates a fifth example of the display device according to the present embodiment,
FIG. 12 illustrates a sixth example of the display device according to the present embodiment,
FIG. 13 illustrates one example of the display device according to the present embodiment,
FIG. 14 illustrates a state in which the display device according to the present embodiment provides information for safe driving,
FIG. 15 illustrates an AR mode of the display device according to the present embodiment,
FIG. 16 illustrates a state in which an active area of the display device according to the present embodiment is changed,
FIG. 17 illustrates an example in which the display device according to the present embodiment displays various types of information.

### [Best Mode]

Hereinafter, specific embodiments of the present disclosure will be described in detail with reference to the drawings.

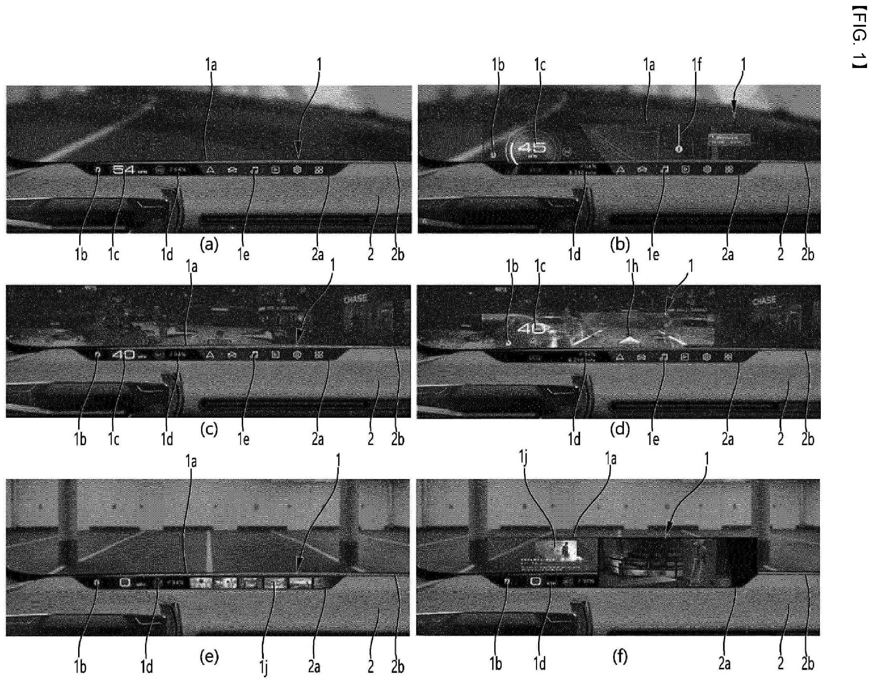

FIG. 1 illustrates a display device according to the present embodiment.

The display device 1 may be disposed on a dashboard 2 and may be raised or lowered with respect to the dashboard 2.

A recessed portion 2a may be formed in the dashboard 2. The recessed portion 2a may be formed at a position at which a portion of the display device 1 is visible when the display device 1 is lowered.

The display device 1 may operate in various modes according to driving, traffic congestion, and stopping of the vehicle.

FIG. 1 (a) illustrates a state in which the display device is in a first mode while the vehicle is being driven.

In the first mode, the display device 1 may be in a lowered mode, an upper end 1a of the display device 1 may be at a height equal to or close to a height of an upper end 2b of the dashboard 2, the display device 1 may display information through a portion of an upper region thereof, and an occupant may check the information displayed by the display device 1 through the recessed portion 2a of the dashboard 2.

In the first mode, the display device 1 may display various driving information 1b, such as forward driving, reverse driving, or parking of the vehicle, speed information 1c, charging information 1d, and various icons 1e.

FIG. 1 (b) illustrates a state in which the display device is in a second mode while the vehicle is being driven.

In the second mode, the display device 1 may be in a raised mode, the upper end 1a of the display device 1 may be raised to a height higher than the height of the upper end 2b of the dashboard 2, the display device 1 may display information over a wider display area than in the first mode, and an occupant may check the information displayed by the display device 1.

In the second mode, the display device 1 may display various driving information 1b, such as forward driving, reverse driving, or parking of the vehicle, speed information 1c, and navigation information 1f through an upper display area, and may display charging information 1d and various icons 1e through a lower display area.

FIG. 1 (c) illustrates a state in which the transparent display device is in a third mode while the vehicle is in traffic congestion.

In the third mode, the display device 1 may be in a lowered mode, the upper end 1a of the display device 1 may be at a height equal to or close to the height of the upper end 2b of the dashboard 2, the display device 1 may display information through a portion of an upper region thereof, and an occupant may check the information displayed by the display device 1 through the recessed portion 2a of the dashboard 2.

In the third mode, the display device 1 may display various driving information 1b, such as forward driving, reverse driving, or parking of the vehicle, speed information 1c, charging information 1d, and various icons 1e.

The third mode may be the same as the first mode.

FIG. 1 (d) illustrates a state in which the transparent display device is in a fourth mode while the vehicle is in traffic congestion.

In the fourth mode, the display device 1 may be in a raised mode, the upper end 1a of the display device 1 may be at a height equal to or close to the height of the upper end 2b of the dashboard 2, the display device 1 may display information over a wider display area than in the first mode or the third mode, and an occupant may check the information.

In the fourth mode, the display device 1 may display various driving information 1b, such as forward driving, reverse driving, or parking of the vehicle, speed information 1c, and image information 1h of a front side or a rear side of the vehicle through an upper display area, and may display charging information 1d and various icons 1e through a lower display area.

FIG. 1 (e) illustrates a state in which the transparent display device is in a fifth mode while the vehicle is stopped.

In the fifth mode, the display device 1 may be in a lowered mode, the upper end 1a of the display device 1 may be at a height equal to or close to the height of the upper end 2b of the dashboard 2, the display device 1 may display information through a portion of an upper region thereof, and an occupant may check the information displayed by the display device 1 through the recessed portion 2a of the dashboard 2.

In the fifth mode, the display device 1 may display various driving information 1b, such as forward driving, reverse driving, or parking of the vehicle, charging information 1d, and media information 1j.

FIG. 1 (f) illustrates a state in which the transparent display device is in a sixth mode while the vehicle is stopped.

In the sixth mode, the display device 1 may be in a raised mode, the upper end 1a of the display device 1 may be at a height equal to or close to the height of the upper end 2b of the dashboard 2, the display device 1 may display information over a wider display area than in the first mode, the third mode, or the fifth mode, and an occupant may check the information displayed by the display device 1.

In the sixth mode, the display device 1 may display media information 1j through an upper display area and may display various driving information 1b, such as forward driving, reverse driving, or parking of the vehicle, and charging information 1d through a lower display area.

As illustrated in FIG. 1, the display device 1 may provide various types of information, and, as illustrated in FIGS. 1 (a), 1 (c), and 1 €, obstruction of a driver's field of view by the display device 1 can be minimized, and, as illustrated in FIG. 1 (f), the media information 1j can be expanded.

The display device 1 may utilize characteristics of the transparent display and may provide a display desired by an occupant in various environments.

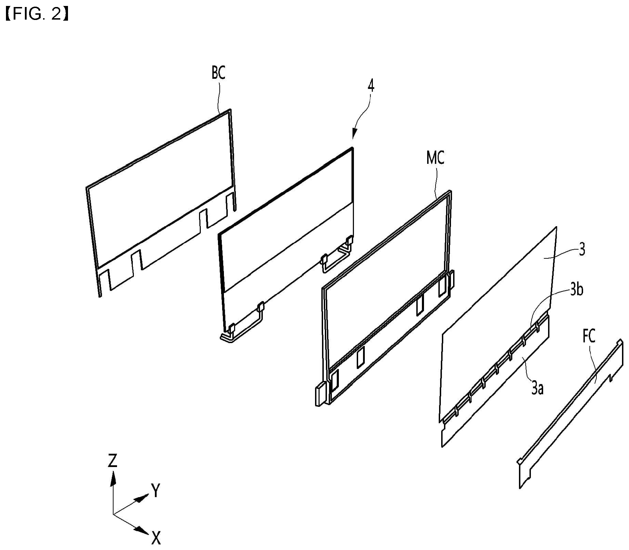

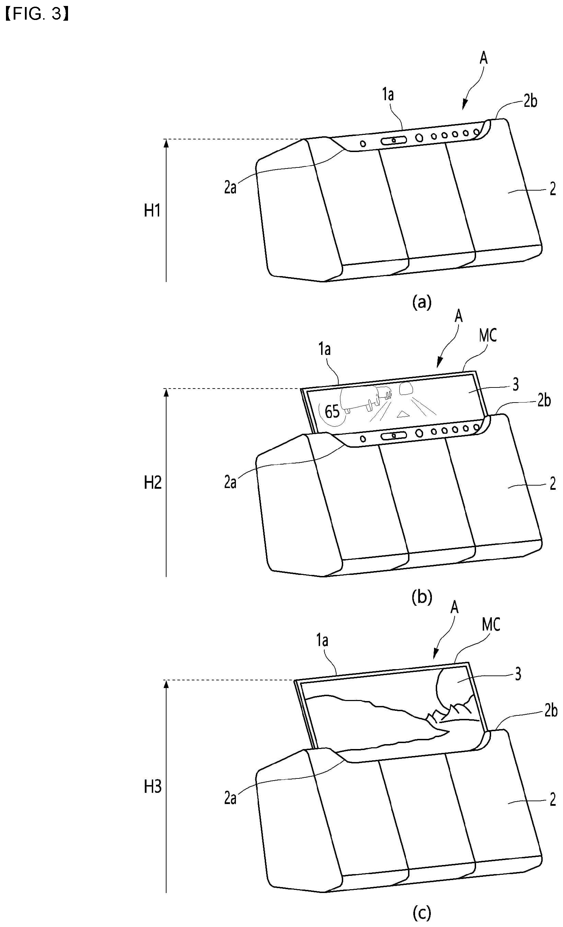

FIG. 2 illustrates various modes of the display device according to the present embodiment and FIG. 3 is an exploded perspective view of the display device according to the present embodiment.

The display device 1 may include a transparent display 3 and a light-shielding cell 4.

One example of the transparent display 3 may include a Transparent Organic Light Emitting Diode (TOLED).

A control board 3a configured to control the transparent display 3 may be connected to the transparent display 3 through a flexible cable 3b.

The light-shielding cell 4 may be disposed to face the transparent display 3. The light-shielding cell 4 may be disposed behind the transparent display 3.

The light-shielding cell 4 may be a transparency adjustment unit configured to adjust transparency and may adjust visibility of information displayed on the transparent display 3.

An opaque liquid fluid may be accommodated in the light-shielding cell 4. The opaque liquid fluid may be accommodated in an inner space formed inside the light-shielding cell 4.

The light-shielding cell 4 may operate in a transparent mode and an opaque mode.

The light-shielding cell 4 may be in the transparent mode or the opaque mode according to a height of the opaque liquid fluid.

The light-shielding cell 4 may vary the height of the opaque liquid fluid.

When the height of the opaque liquid fluid is low, the light-shielding cell 4 may be in the transparent mode, and when the height of the opaque liquid fluid is high, the light-shielding cell 4 may be in the opaque mode.

The display device 1 may include a cover. A plurality of covers may be provided. The plurality of covers FC, MC, and BC may include a front cover FC, a middle cover MC, and a back cover BC.

The front cover FC may be disposed in front of the control board 3a and the flexible cable 3b and may cover the control board 3a and the flexible cable 3b.

The middle cover MC may surround an edge of the transparent display 3 and an edge of the light-shielding cell 4. The middle cover MC may support the transparent display 3 and the light-shielding cell 4.

The back cover BC may be disposed behind the light-shielding cell 4.

The front cover FC, the transparent display 3, the control board 3a, the flexible cable 3b, the middle cover MC, the light-shielding cell 4, and the back cover BC may be integrated to constitute an assembly A.

An upper end of the assembly A may be an upper end of the display device 1.

The display device 1 may further include a lifter (not shown).

The lifter may be accommodated in a space formed inside the dashboard 2 and may be protected by the dashboard 2.

The lifter may lower the assembly A to a lower height H1 and may raise the assembly A to higher heights H2, H3.

The lower height H1 may be a height at which the upper end 1a of the assembly A is equal to or close to a height of the upper end 2a of the dashboard 2.

The higher heights H2, H3 may be heights at which the upper end 1a of the assembly A is higher than the height of the upper end 2a of the dashboard 2.

The display device 1 may operate in one of a minimal driving mode, an AR (Augmented Reality) driving mode, and an entertainment mode.

The lifter may vary a position (or height) of the transparent display 3 and a position (or height) of the light-shielding cell 4 in response to an operating mode of the transparent display 3.

In the minimal driving mode, as illustrated in FIG. 2 (a), the upper end 1a of the assembly A may be at a first height H1 equal to or close to the height of the upper end 2b of the dashboard 2.

In the minimal driving mode, the height of the opaque liquid fluid may be an upper height of the light-shielding cell 4. Here, the upper height may be a height of an upper portion of the inner space of the light-shielding cell 4.

In the AR driving mode, as illustrated in FIG. 2 (b), the upper end 1a of the assembly A may be at a second height H2 higher than the height of the upper end 2b of the dashboard 2. The second height H2 may be higher than the first height H1.

In the AR driving mode, the height of the opaque liquid fluid may be an intermediate height of the light-shielding cell 4. Here, the intermediate height may be a height of an intermediate portion of the inner space of the light-shielding cell 4.

In the entertainment mode, as illustrated in FIG. 2(c), the upper end 1a of the assembly A may be at a third height H3 higher than the height of the upper end 2b of the dashboard 2. The third height H3 may be higher than the second height H2.

In the entertainment mode, the height of the opaque liquid fluid may be the upper height of the light-shielding cell 4.

In a driving mode of the vehicle, the display device 1 may perform the minimal driving mode or the AR driving mode.

In a parking mode of the vehicle, the display device 1 may perform the entertainment mode.

When the vehicle changes from the parking mode to a driving mode, the display device 1 may change from the entertainment mode to the minimal driving mode or the AR driving mode.

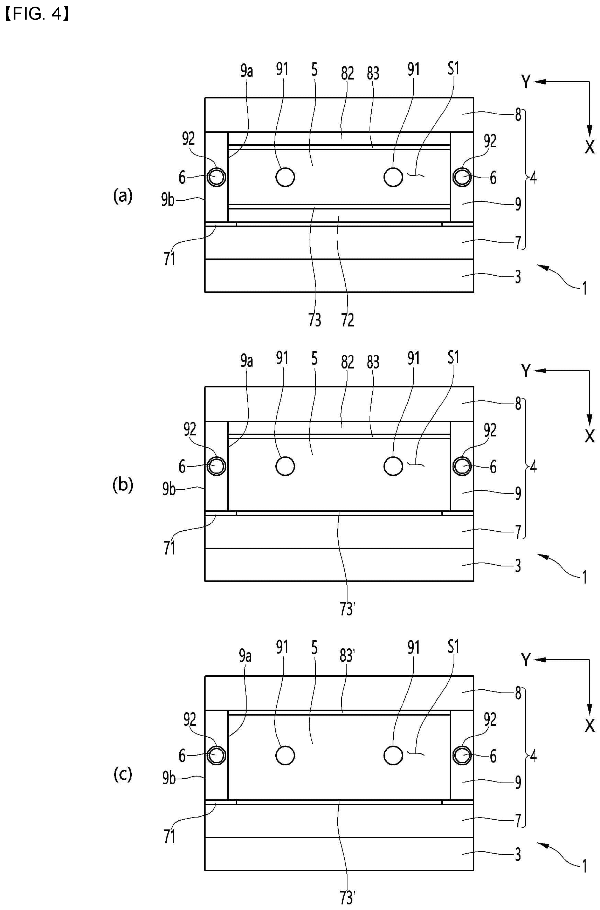

FIG. 4 is a schematic view illustrating an example of a light-shielding cell according to the present embodiment.

FIG. 4 (a) illustrates one example of the light-shielding cell.

An inner space S1 configured to accommodate at least one of a first fluid 5 and a second fluid 6 may be formed in the light-shielding cell 4.

The inner space S1 may be formed inside the light-shielding cell 4.

The first fluid 5 and the second fluid 6 may be accommodated together in the inner space S1, or one of the first fluid 5 and the second fluid 6 may be accommodated in the inner space S1.

The first fluid 5 and the second fluid 6 may remain separated while interfacing with each other in the inner space S1.

Among the first fluid 5 and the second fluid 6, one fluid may be a colored fluid, and the other fluid may be a colorless fluid.

Among the first fluid 5 and the second fluid 6, one fluid may be in a liquid state, and the other fluid may be in a gaseous state.

Among the first fluid 5 and the second fluid 6, one fluid may be a colored liquid, and the other fluid may be a colorless liquid.

Various examples may be applied to the first fluid 5 and the second fluid 6, and any two fluids having different transparencies may be applied.

Hereinafter, for convenience of description, the first fluid 5 will be described as a colored liquid and the second fluid 6 will be described as a transparent liquid or air, but the present disclosure is not limited thereto.

A specific gravity of the first fluid 5 may be different from a specific gravity of the second fluid 6.

For example, the specific gravity of the first fluid 5 may be greater than the specific gravity of the second fluid 6.

When the first fluid 5 and the second fluid 6 are accommodated together in the inner space S1, the second fluid 6 may maintain an interface with the first fluid 5 and may be positioned above the first fluid 5.

The second fluid 6 may be floated by the first fluid 5.

When the second fluid 6 is accommodated in the inner space S1 and the first fluid 5 is not accommodated in the inner space S1, the light-shielding cell 4 may be in a transparent mode.

When the first fluid 5 and the second fluid 6 are accommodated together in the inner space S1, and an area in which the second fluid 6 is accommodated is greater than an area in which the first fluid 5 is accommodated, the light-shielding cell 4 may be in the transparent mode.

In the transparent mode of the light-shielding cell 4, an occupant may recognize a front side of the vehicle through the transparent display 3 and the light-shielding cell 4, and the display device may not obstruct the occupant's driving field of view.

When the first fluid 5 is accommodated in the inner space S1 and the second fluid 6 is not accommodated in the inner space S1, the light-shielding cell 4 may be in an opaque mode.

When the first fluid 5 and the second fluid 6 are accommodated together in the inner space S1, and an area in which the first fluid 5 is accommodated is greater than an area in which the second fluid 6 is accommodated, the light-shielding cell 4 may be in the opaque mode.

In the opaque mode of the light-shielding cell 4, the light-shielding cell 4 may function as a screen behind the transparent display 3, an occupant can more clearly recognize information displayed by the transparent display 3, and visibility of the display device 1 can be improved.

The light-shielding cell 4 may include a front glass 7 facing the transparent display 3, a rear glass 8 facing the front glass 7, and a sealing member 9 disposed between the front glass 7 and the rear glass 8.

The front glass 7 and the rear glass 8 may be glasses of the light-shielding cell 4.

Each of the front glass 7 and the rear glass 8 may be transparent.

The front glass 7 and the rear glass 8 may be parallel to each other.

The front glass 7 and the rear glass 8 may be spaced apart from each other. The front glass 7 and the rear glass 8 may be spaced apart from each other in a front-rear direction X.

The inner space S1 may be formed between the front glass 7 and the rear glass 8, and at least one of the first fluid 5 and the second fluid 6 may be accommodated between the front glass 7 and the rear glass 8.

The light-shielding cell 4 may include a bezel layer 71.

The bezel layer 71 may be formed at an edge of a rear surface of the front glass 7.

A shape of the bezel layer 71 may be the same as a shape of the edge of the front glass 7.

The bezel layer 71 may, for example, be black and may be formed by a printing process or the like.

The bezel layer 71 may form a sealing line and may conceal the sealing member 9 from a front side of the sealing member 9.

The light-shielding cell 4 may further include a front film 72.

The front film 72 may be disposed on the rear surface of the front glass 7.

A water-repellent treatment layer 73 may be formed on a surface of the front film 72 facing the inner space S1, and the water-repellent treatment layer 73 may be a front water-repellent layer formed on the rear surface of the front film 72.

The light-shielding cell 4 may further include a rear film 82.

The rear film 82 may be disposed on a front surface of the rear glass 8.

A water-repellent treatment layer 83 may be formed on a surface of the rear film 82 facing the inner space S1, and the water-repellent treatment layer 83 may be a rear water-repellent layer formed on the front surface of the rear film 82.

The sealing member 9 may have a closed-loop cross-sectional shape. The sealing member 9 may form a peripheral portion of the display device 1, may seal between the front glass 7 and the rear glass 8, and may be disposed behind the bezel layer 71.

The inner space S1 may be formed inside the sealing member 9. An inner peripheral portion 9a of the sealing member 9 may define the inner space S1. The inner space S1 may be defined as a space formed inside the inner peripheral portion 9a of the sealing member 9.

The sealing member 9 may be formed of a flexible material such as rubber or silicone.

The sealing member 9 may seal between the front glass 7 and the rear glass 8 and may hermetically seal between the front glass 7 and the rear glass 8.

The sealing member 9 may provide waterproofing.

The sealing member 9 can prevent condensation due to a temperature difference, can prevent evaporation of the first fluid 5 or the second fluid 6, and can minimize penetration of foreign substances into the inner space S1.

A first inlet/outlet 91 and a second inlet/outlet 92 may be formed in the sealing member 9.

The first inlet/outlet 91 may be formed in a portion of the sealing member 9.

The first fluid 5 may flow into the inner space S1 through the first inlet/outlet 91, and the first fluid 5 in the inner space S1 may flow out through the first inlet/outlet 91.

The second inlet/outlet 92 may be formed in another portion of the sealing member 9.

The second fluid 6 may flow into the inner space S1 through the second inlet/outlet 92, and

the second fluid 6 in the inner space S1 may flow out through the second inlet/outlet 92.

At least one of the first inlet/outlet 91 and the second inlet/outlet 92 may be formed between the inner peripheral portion 9a of the sealing member 9 and an outer peripheral portion 9b of the sealing member 9.

The second inlet/outlet 92 may not directly be connected to the first inlet/outlet 91, and the first fluid 5 passing through the first inlet/outlet 91 and the second fluid 6 passing through the second inlet/outlet 92 may not be mixed with each other.

FIG. 4 (b) illustrates another example of the light-shielding cell.

Another example of the light-shielding cell 4 may include a water-repellent treatment layer 73' formed on one of the rear surface of the front glass 7 and the front surface of the rear glass 8.

The water-repellent treatment layer 73' may be formed on the rear surface of the front glass 7 and may be surrounded by the bezel layer 71.

The rear surface of the front glass 7 may be protected by the water-repellent treatment layer 73' positioned on an inner side and the bezel layer 71 positioned on an outer side.

Another example of the light-shielding cell may omit the front film 72 illustrated in FIG. 2, a rear film 82 may be disposed on the front surface of the rear glass 8, and the water-repellent treatment layer 83 may be formed on the front surface of the rear film 82.

The water-repellent treatment layer 73' formed on the rear surface of the front glass 7 may be a front water-repellent layer, and the water-repellent treatment layer 83 formed on the front surface of the rear film 82 may be a rear water-repellent layer.

Another example of the light-shielding cell may have the same or similar configuration and operation as one example of the light-shielding cell 4, except that the water-repellent treatment layer 73' is directly formed on the rear surface of the front glass 7. Accordingly, the same reference numerals are used below for convenience, and a detailed description thereof will be omitted.

FIG. 4 (c) illustrates the other example of the light-shielding cell.

The other example of the light-shielding cell may include a water-repellent treatment layer 73' formed on the rear surface of the front glass 7 and a water-repellent treatment layer 83' formed on the front surface of the rear glass 8.

The water-repellent treatment layer 73' formed on the rear surface of the front glass 7 may be surrounded by the bezel layer 71.

The rear surface of the front glass 7 may be protected by the water-repellent treatment layer 73' positioned on an inner side and the bezel layer 71 positioned on an outer side.

The water-repellent treatment layer 73' formed on the rear surface of the front glass 7 may be a front water-repellent layer, and the water-repellent treatment layer 83' formed on the front surface of the rear glass 8 may be a rear water-repellent layer.

The front glass 7 may include a first surface adjacent to the transparent display 3 and a second surface opposite to the first surface.

The front water-repellent treatment layer 73' may be formed on the second surface.

The rear glass 8 may include a third surface adjacent to the second surface and a fourth surface opposite to the third surface.

The rear water-repellent treatment layer 83' may be formed on the third surface.

The front water-repellent treatment layer 73' and the rear water-repellent treatment layer 83' may face each other in the front-rear direction X, and the first fluid 5 or the second fluid 6 between the front water-repellent treatment layer 73' and the rear water-repellent treatment layer 83' can rapidly flow.

The other example of the light-shielding cell may have the same or similar configuration and operation as one example of the light-shielding cell 4, except that the water-repellent treatment layer 73' is directly formed on the rear surface of the front glass 7 and the water-repellent treatment layer 83' is directly formed on the front surface of the rear glass 8. Accordingly, the same reference numerals are used below for convenience, and a detailed description thereof will be omitted.

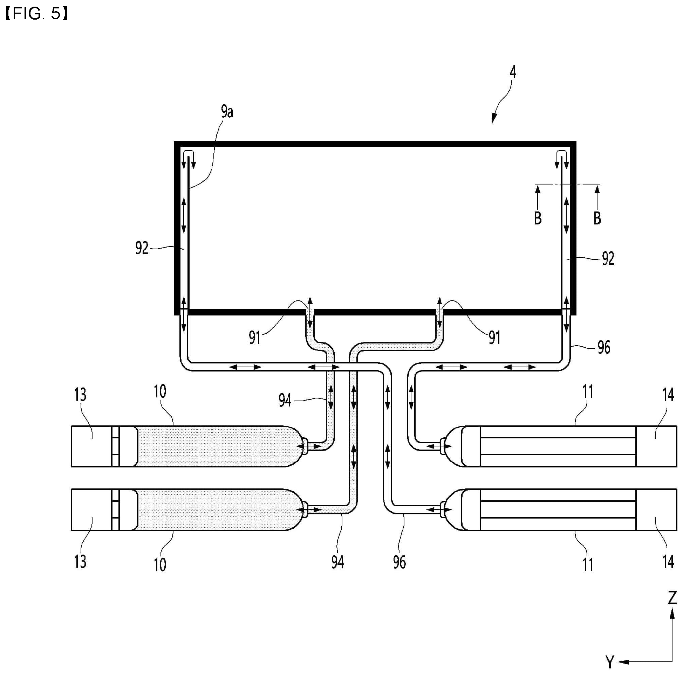

FIG. 5 illustrates a light-shielding cell and a reservoir according to the present embodiment.

The display device may include a first reservoir 10 configured to accommodate the first fluid 5, a second reservoir 11 configured to accommodate the second fluid 6, a first fluid passage 94 disposed between the first reservoir 10 and the first inlet/outlet 91, and a second fluid passage 96 disposed between the second reservoir 11 and the second inlet/outlet 92.

The first fluid 5 may be a liquid fluid having a color such as black, and the first reservoir 10 may be a liquid tank.

A single first reservoir 10 may be provided, or a plurality of first reservoirs 10 may be provided.

The second fluid 6 may be a transparent gas, for example, air, and the second reservoir 11 may be an air tank.

A single second reservoir 11 may be provided, or a plurality of second reservoirs 11 may be provided.

At least one of the first reservoir 10 and the second reservoir 11 may be disposed below the transparent display 3.

A first actuator 12 may be connected to the first reservoir 10.

The first actuator 13 may include a first driving source such as a motor, and a first syringe operated upon driving of the first driving source.

The first actuator 13 may be a liquid tank driving unit 13, and will be described below with the same reference numeral.

The first syringe may push the first fluid 5 accommodated in the first reservoir 10 from the first reservoir 10 to the first fluid passage 94, and may cause the fluid in the first fluid passage 94 to flow to the first reservoir 10.

A second actuator 14 may be connected to the second reservoir 11.

The second actuator 14 may include a second driving source such as a motor, and a second syringe operated upon driving of the driving source.

The second actuator 14 may be an air tank driving unit, and will be described below with the same reference numeral.

The second syringe may push the second fluid 6 accommodated in the second reservoir 11 from the second reservoir 11 to the second fluid passage 96, and may cause the fluid in the second fluid passage 96 to flow to the second reservoir 11.

The first fluid passage 94 may be connected to each of the inner space S1 and the first reservoir 10.

The first fluid passage 94 may be connected to the inner space S1 through the first inlet/outlet 91.

A plurality of first fluid passages 94 may be provided, and a plurality of first inlet/outlets 91 may be provided to correspond to the plurality of first fluid passages 94.

A pair of first inlet/outlets 91 may be formed in the sealing member 9. The pair of first inlet/outlets 91 may be spaced apart from each other in the left-right direction Y.

When the pair of inlet/outlets 91 are formed in the sealing member 9, the display device may be provided with a pair of first fluid passages 94.

The first inlet/outlet 91 and the first fluid passage 94 may correspond to each other on a one-to-one basis.

The second fluid passage 96 may be connected to each of the inner space S1 and the second reservoir 11.

The second fluid passage 96 may be connected to the inner space S1 through the second inlet/outlet 92.

A plurality of second fluid passages 96 may be provided, and a plurality of second inlet/outlets 92 may be provided to correspond to the plurality of second fluid passages 96.

A pair of second inlet/outlets 92 may be formed in the sealing member 9. The pair of second inlet/outlets 92 may be spaced apart from each other in the left-right direction Y.

When the pair of second inlet/outlets 92 are formed in the sealing member 9, the display device may be provided with a pair of second fluid passages 96.

The second inlet/outlet 92 and the second fluid passage 96 may correspond to each other on a one-to-one basis.

For example, a single first reservoir 10 may be provided, and the first fluid 5 accommodated in the first reservoir 10 may be branched into the plurality of first fluid passages 94 and may move into the inner space S1 through the plurality of first fluid passages 94. In addition, a single second reservoir 11 may be provided, and the second fluid 6 accommodated in the second reservoir 11 may be branched into the plurality of second fluid passages 96 and may move into the inner space through the plurality of second fluid passages 96.

As another example, a plurality of first reservoirs 10 and a plurality of first fluid passages 94 may be provided, and a plurality of second reservoirs 11 and a plurality of second fluid passages 96 may be provided.

In this case, the first fluid 5 accommodated in one of the plurality of first reservoirs 10 may move into the inner space S1 through one of the plurality of first fluid passages 94, and the first fluid 5 accommodated in another one of the plurality of first reservoirs 10 may move into the inner space S1 through another one of the plurality of first fluid passages 94. In addition, the second fluid 6 accommodated in one of the plurality of second reservoirs 11 may move into the inner space S1 through one of the plurality of second fluid passages 96, and the second fluid 6 accommodated in another one of the plurality of second reservoirs 11 may move into the inner space S1 through another one of the plurality of second fluid passages 96.

Among the first fluid 5 and the second fluid 6, a fluid having a higher specific gravity may flow into the inner space S1 through a lower portion of the inner space S1 or may flow out through the lower portion of the inner space S1.

Among the first fluid 5 and the second fluid 6, a fluid having a lower specific gravity may flow into the inner space S1 through an upper portion of the inner space S1 or may flow out through the upper portion of the inner space S1.

An upper end of the first inlet/outlet 91 may be closer to a lower end among an upper end and the lower end of the light-shielding cell 4.

An upper end of the second inlet/outlet 92 may be closer to an upper end among the upper end and a lower end of the light-shielding cell 4.

When the first fluid 5 accommodated in the first reservoir 10 flows into the inner space S1 through the first fluid passage 94 and the first inlet/outlet 91, the second fluid 6 accommodated in the inner space S1 may move to the second reservoir 11 through the second inlet/outlet 92 and the second fluid passage 96.

Conversely, when the second fluid 6 accommodated in the second reservoir 11 flows into the inner space S1 through the second fluid passage 96 and the second inlet/outlet 92, the first fluid 5 accommodated in the inner space S1 may move to the first reservoir 10 through the first inlet/outlet 91 and the first fluid passage 94.

A pair of each of the first reservoir 10, the liquid tank driving unit 13, the first fluid passage 94, and the first inlet/outlet 91 may be provided, and a pair of each of the second reservoir 11, the air tank driving unit 14, the second fluid passage 96, and the second inlet/outlet 92 may be provided.

The display device may further include a controller (not shown) configured to control the pair of liquid tank driving units 13, the pair of air tank driving units 14, and the lifter.

The controller may control the pair of liquid tank driving units 13, the pair of air tank driving units 14, and the lifter according to surrounding conditions of the vehicle, surrounding conditions of the vehicle, a command of an occupant, or the like.

The display device can minimize consumer perception caused by a delay in a change time between transparency and opacity by linking a moving speed of the liquid with a display driving speed.

The controller may connect control of the pair of liquid tank driving units 13, the pair of air tank driving units 14, and the lifter in consideration of a moving distance of the first fluid 5 or the second fluid 6, a volume change in the first reservoir 10 or the second reservoir 11, and the like.

At an initial stage of the display device, the light-shielding cell 4 may be transparent, and thereafter, the light-shielding cell 4 may be opaque.

When the transparent display 3 is driven, a ratio between a transparent region in which the second fluid is accommodated and an opaque region in which the first fluid is accommodated may be adjusted.

When the vehicle is started or at an initial stage of driving of the display device, the first fluid may fill the transparent region, the transparent display 3 may display an initial screen, and driver information may be displayed.

Thereafter, as the first fluid 5 moves downward in the inner space S1, the second fluid 6 may fill the inner space S2, information related to driving of the vehicle may be displayed in the transparent region, and menus or the like may be displayed. The transparent region may be used in various modes.

Thereafter, when the vehicle is driven, the transparent region may operate as an AR driving mode.

During driving of the vehicle, transparency adjustment and object AR graphics may be displayed to secure visibility according to surrounding conditions.

To secure visibility in weather such as rain or fog, another vehicle on a road may be displayed in the transparent region as AR graphics. In this case, a partial light-shielding mode may be applied to a background.

Through a sensor such as ADAS, an object other than a vehicle may also be displayed in the transparent region as AR graphics on a sparsely populated road without streetlights.

Even during a bright daytime, when a sudden obstacle is detected, a notification display may be displayed around the obstacle in the transparent region as AR graphics.

When the driving of the vehicle is stopped, when the vehicle is stationary, or during autonomous driving of the vehicle, the display device may be implemented as a light-shielding mode for viewing content.

The transparent region and the opaque region may be separated, or a selective use environment in which full-surface opacity is available may be provided, and in this case, left and right liquid inflows may be separately introduced.

The transparent region may be used in a lowered state or in an AR mode according to a driving situation of the vehicle.

When content is viewed while the vehicle is stopped or stationary, a height of the opaque region may be adjusted according to a ratio suitable for a type, and content display may be displayed.

When an active region is driven upward and downward, a front surface of the active region light-shielding mode may be exposed to maximize an experience in which content can be viewed at a ratio suitable for a movie, a game, or the like.

While content is displayed, the active region may be movable upward and downward to correspond to the ratio.

According to a ratio suitable for content, liquid light-shielding films on a left side, a right side, or left and right sides of the active region may be divided and displayed, and driving for adjustment of the ratio may be seamlessly performed in consideration of a liquid inflow time.

Even while content is being viewed, the active region may move upward and downward based on a driving state of the vehicle, such as an increase in driving speed or a driving mode change, and may be switched from the light-shielding mode to the transparent mode. At this time, since switching to the transparent mode takes some time, upward and downward driving may be performed first according to the driving state.

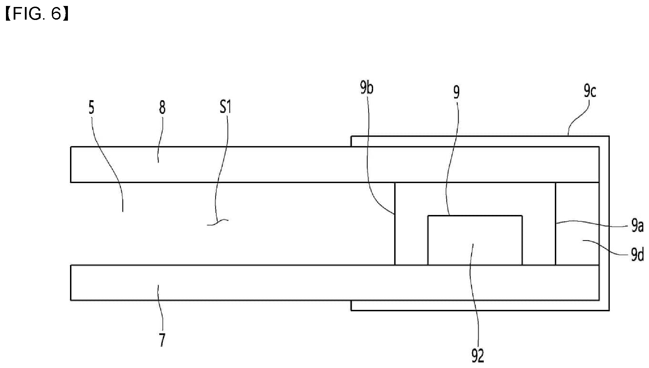

FIG. 6 is a cross-sectional view taken along line B-B of FIG. 5.

The display device may further include a bezel 9c configured to fix the front glass 8 and the rear glass 8.

An area of the bezel 9c may be greater than a projected area of the sealing member 9.

A cross-sectional shape of the bezel 9c may be "⊏".

The bezel 9c may hide the sealing member 9.

The display device may further include a curing agent 9d formed on one side of the sealing member 9. The curing agent 9d may be formed outside the outer peripheral portion 9b of the sealing member 9. The curing agent 9d may be formed between the outer peripheral portion 9b of the sealing member 9 and the bezel 9c.

The bezel 9c may include a front bezel disposed at a front edge of the front glass 7, a rear bezel disposed at a rear edge of the rear glass 8, and an outer bezel connecting the front bezel and the rear bezel.

The front bezel may be spaced apart from the sealing member 9 with the front glass 7 interposed therebetween.

The rear bezel may be spaced apart from the sealing member 9 with the rear glass 8 interposed therebetween.

The outer bezel may be spaced apart from the sealing member 9 with the curing agent 9d interposed therebetween.

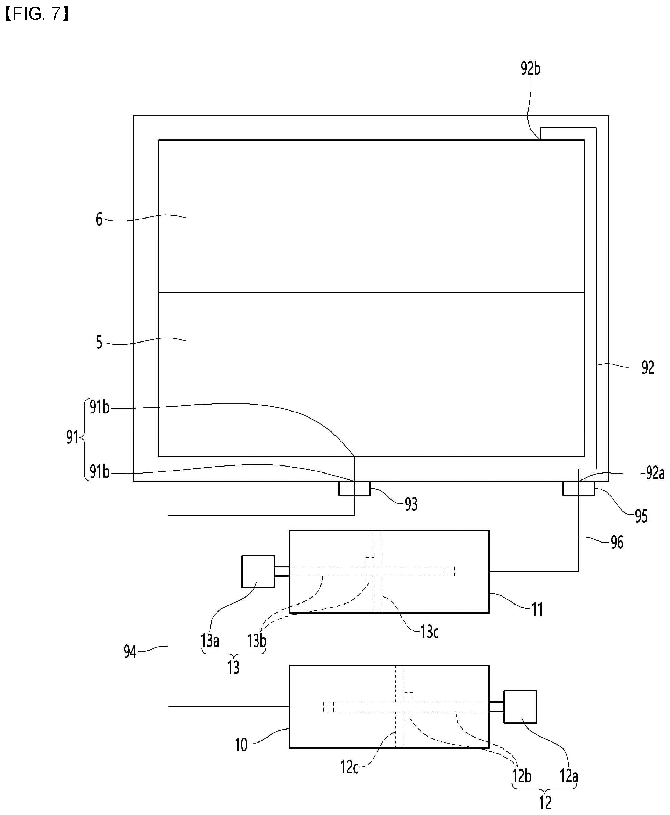

FIG. 7 illustrates a modified example of the light-shielding cell and the reservoir according to the present embodiment.

The display device 1 may include a reservoir in which the first fluid 5 and the second fluid 6 are stored.

When the first fluid 5 and the second fluid 6 are liquid, the reservoir may be a liquid reservoir.

When the first fluid 5 and the second fluid 6 are air, the reservoir may be an air reservoir.

The display device 1 may include a first reservoir 10 configured to accommodate the first fluid 5, and a second reservoir 11 configured to accommodate the second fluid 6.]

The first reservoir 10 and the second reservoir 11 may be integrally formed or may be disposed to be spaced apart from each other.

One example of the first reservoir 10 may be disposed below the transparent display 3 or the light-shielding cell 4.

The first reservoir 10 in which the first fluid 5 having a higher specific gravity is stored may be disposed at a lower end of the light-shielding cell 4.

Another example of the first reservoir 10 may be disposed behind the light-shielding cell 4.

One example of the second reservoir 11 may be disposed at the same height as the first reservoir 10.

A height of another example of the second reservoir 11 may be different from a height of the first reservoir 10. Another example of the second reservoir 11 may be disposed above the first reservoir 10.

Each of the first reservoir 10 and the second reservoir 11 may be connected to the light-shielding cell 4 through a fluid passage and a coupler.

The display device 1 may further include a first actuator 12 configured to move the first fluid 5, and a second actuator 13 configured to move the second fluid 3.

One example of the first actuator 12 may include a first driving source 12a, at least one first power transmission member 12b operated upon driving of the first driving source 12a, and a first pressure plate 12c connected to the first power transmission member 12b and configured to pressurize the first fluid 5.

An example of the first driving source 12a may be a motor.

An example of the first power transmission member 12b may include a screw rotated by the first driving source 12a, and a lead nut moved along the screw in a longitudinal direction of the screw.

The first pressure plate 12c may be disposed inside the first reservoir 10 to linearly move.

Another example of the first actuator 12 may be a pump installed in the first fluid passage 94.

The first actuator 12 may be applied without limitation to the type thereof as long as the first actuator 12 has a configuration capable of pushing the first fluid 5 in the first reservoir 10 to the outside of the first reservoir 10 or pulling the first fluid 5 outside the first reservoir 10 into the first reservoir 10.

The second actuator 13 may include a second driving source 13a, at least one second power transmission member 13b operated upon driving of the second driving source 13a, and a second pressure plate 13c connected to the second power transmission member 13b and configured to pressurize the second fluid 6.

An example of the second driving source 13a may be a motor.

An example of the second power transmission member 13b may include a screw rotated by the second driving source 13a, and a lead nut moved along the screw in a longitudinal direction of the screw.

The second pressure plate 13c may be disposed inside the second reservoir 11 to linearly move.

Another example of the second actuator 13 may be a pump installed in the second fluid passage 96.

The second actuator 13 may be applied without limitation to the type thereof as long as the second actuator 13 has a configuration capable of pushing the second fluid 6 in the second reservoir 11 to the outside of the second reservoir 11 or pulling the second fluid 6 outside the second reservoir 11 into the second reservoir 11.

The first inlet/outlet 91 formed in the sealing member 8 may be connected to each of the inner space S1 and the first reservoir 10.

The first inlet/outlet 91 may include a first port 91a and a second port 91b.

The first port 91a may be one end of the first inlet/outlet 91, and the second port 91b may be the other end of the first inlet/outlet 91.

The first inlet/outlet 91 may include an inner passage connecting the first port 91a and the second port 91b.

The first fluid 5 may flow into the first inlet/outlet 91 through the first port 91a, and may move into the inner space S1 through the second port 91b.

The first fluid 5 accommodated in the inner space S1 may flow into the first inlet/outlet 91 through the second port 91b, and may exit the sealing member 9 through the first port 91a.

A first coupler 93 may be connected to the first port 91a of the first inlet/outlet 91, the first fluid passage 94 may be connected to the first coupler 93, and the first fluid passage 94 may be connected to the first reservoir 10.

The first fluid passage 94 may be a first liquid flow pipe configured to guide flow of the first liquid 5 between the first reservoir 10 and the light-shielding cell 4.

Examples of the first fluid passage 94 may include a tube, a hose, a pipe, or the like through which the first fluid 5 may pass. A preferred example of the first fluid passage 94 may be a flexible tube.

The first fluid 5 accommodated inside the first reservoir 10 may pass through the first fluid passage 94 and the first coupler 93, may then flow to the first inlet/outlet 91, and may pass through the second port 91b inside the sealing member 9 and be accommodated in the inner space S1.

The first fluid 5 accommodated in the inner space S1 may pass through the second port 91b and flow into the inside of the sealing member 9, and may then sequentially pass through the first inlet/outlet 91, the first coupler 93, and the first fluid passage 94 and flow to the first reservoir 10.

The second inlet/outlet 92 formed in the sealing member 9 may be connected to each of the inner space S1 and the second reservoir 11.

The second inlet/outlet 92 may include a third port 92a and a fourth port 92b.

The third port 92a may be one end of the second inlet/outlet 92, and the fourth port 92b may be the other end of the second passage 92.

The second inlet/outlet 92 may include an inner passage connecting the third port 92a and the fourth port 92b.

The second fluid 6 may flow into the second inlet/outlet 92 through the third port 92a, and may move into the inner space S1 through the second port 92b.

The second fluid 6 accommodated in the inner space S1 may flow into the second inlet/outlet 92 through the fourth port 92b, and may exit the sealing member 9 through the third port 92a.

A second coupler 95 may be connected to the third port 92a of the second inlet/outlet 92, the second fluid passage 96 may be connected to the second coupler 95, and the second fluid passage 96 may be connected to the second reservoir 11.

The second fluid passage 96 may be a second liquid flow pipe configured to guide flow of the second liquid 6 between the second reservoir 11 and the light-shielding cell 4.

Examples of the second fluid passage 96 may include a tube, a hose, a pipe, or the like through which the second fluid 6 may pass. A preferred example of the second fluid passage 96 may be a flexible tube.

The second fluid 6 accommodated inside the second reservoir 11 may pass through the second fluid passage 96 and the second coupler 95, may then flow to the second inlet/outlet 92, and may pass through the fourth port 91b inside the sealing member 9 and be accommodated in the inner space S1.

The second fluid 6 accommodated in the inner space S1 may pass through the fourth port 92b and flow into the inside of the sealing member 9, and may then sequentially pass through the second inlet/outlet 92, the second coupler 95, and the second fluid passage 96 and flow to the second reservoir 11.

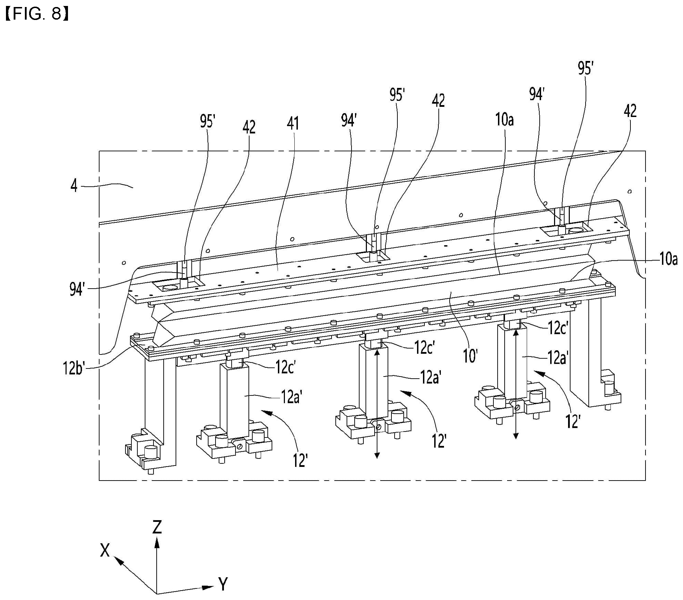

FIG. 8 illustrates a second example of the display device according to the present embodiment.

The display device may include a variable reservoir 10' configured to accommodate the first fluid 5 or the second fluid 6, and an actuator 12' configured to vary an internal volume of the variable reservoir 10'.

The variable reservoir 10' may be deformed in shape in response to driving of the actuator 12'.

Corresponding to a shape of the variable reservoir 10', the stored first fluid 5 or second fluid 6 may be moved to the light-shielding cell 4, or the first fluid 5 or second fluid 6 accommodated in the light-shielding cell 4 may be moved into the variable reservoir 10'.

The variable reservoir 10' may be connected to the light-shielding cell 4. The variable reservoir 10' may be connected to the light-shielding cell 4 through a fluid passage 94' and a coupler 95'.

The variable reservoir 10' may be disposed below the light-shielding cell 4. The variable reservoir 10' may be disposed below the transparent display 3.

The variable reservoir 10' may be elongated in the left-right direction Y.

The variable reservoir 10' may be formed of an elastic material such as rubber. The variable reservoir 10' may be a flexible reservoir that is compressed or expanded. The variable reservoir 10' may be contracted or expanded in the up-down direction Z.

At least one wrinkle 10a may be formed in the variable reservoir 10'. A plurality of wrinkles 10a may be formed in the variable reservoir 10', and the plurality of wrinkles 10a may be elongated in the left-right direction Y.

The variable reservoir 10' may be expanded as the wrinkles 10a are unfolded, and may be compressed as the wrinkles 10a are folded.

An upper portion of the variable reservoir 10' may be connected to a lower body 41 provided in the light-shielding cell 4. An opening 42 through which the fluid passage 94' passes may be formed in the lower body 41.

The variable reservoir 10' may be disposed below the lower body 41.

In response to driving of the actuator 12', the fluid in the variable reservoir 10' may move into the inner space S1.

The actuator 12' may pressurize the variable reservoir 10' from outside the variable reservoir 10'. The actuator 12' may pressurize the variable reservoir 10' upward from below the variable reservoir 10'.

One example of the actuator 12' may be a linear actuator. One example of the actuator 12' may include a linear driving source 12a' and an outer plate 12b' connected to the linear driving source 12a' and raised or lowered upon driving of the driving source 12a'.

The linear driving source 12a' may include a driving source such as a motor. An example of the driving source may be a linear motor.

The linear driving source 12a' may include an elevating member 12c' connected to the outer plate 12b'. The elevating member 12c' may be raised or lowered by the linear motor and may raise or lower the outer plate 12b'.

A plurality of linear driving sources 12a' may be provided. The plurality of linear driving sources 12a' may be spaced apart from each other in a direction parallel to a longitudinal direction of the variable reservoir 10'. The plurality of linear driving sources 12a' may be spaced apart from each other in the left-right direction Y.

The outer plate 12b' may be disposed outside the variable reservoir 10'. The outer plate 12b' may be connected to a lower portion of the variable reservoir 10'.

When the outer plate 12b' is raised, the variable reservoir 10' may be compressed, and the fluid accommodated in the variable reservoir 10' may flow into the inner space S of the light-shielding cell 4 through the fluid passage 94'.

When the outer plate 12b' is lowered, the variable reservoir 10' may be expanded, and the fluid accommodated in the inner space S1 of the light-shielding cell 4 may move to the variable reservoir 10' through the fluid passage 94' and may be accommodated in the variable reservoir 10'.

At least one of a first reservoir configured to accommodate the first fluid 5 and a second reservoir configured to accommodate the second fluid may be the variable reservoir 10' having a variable internal volume.

The first reservoir may be the variable reservoir 10' configured to accommodate the first fluid 5 and having a variable internal volume, and the second reservoir 11 may be a reservoir configured to accommodate the second fluid 6 and having a constant internal volume.

The first reservoir may be a reservoir 10 configured to accommodate the first fluid 5 and having a constant internal volume, and the second reservoir 11 may be the variable reservoir 10' configured to accommodate the second fluid 6 and having a variable internal volume.

One fluid among the first fluid 5 and the second fluid 6 may be liquid, and the other fluid among the first fluid 5 and the second fluid 6 may be gas.

The present embodiment may have the same or similar configuration as the first example of the display device, except for the variable reservoir 10' and the actuator 12', and the same reference numerals are used for convenience, and description thereof is omitted.

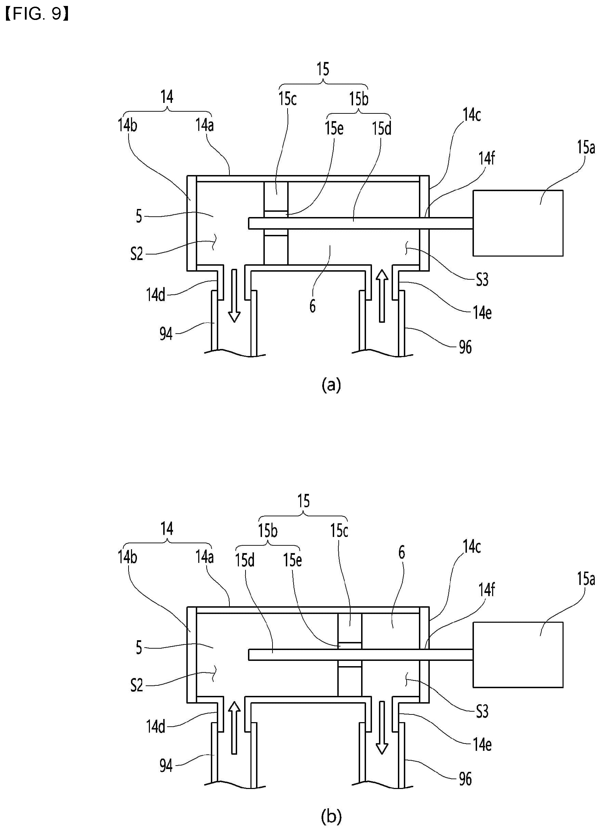

FIG. 9 illustrates a third example of the display device according to the present embodiment.

The third example of the display device may include a reservoir 14 and an actuator 15.

The present embodiment may have the same or similar configuration as the first example of the display device, except for the reservoir 14 and the actuator 15, and the same reference numerals are used for convenience, and description thereof is omitted.

A first storage space S2 configured to accommodate the first fluid 5 and a second storage space S3 configured to accommodate the second fluid 6 may be formed in the reservoir 14.

The reservoir 14 may include a first reservoir portion and a second reservoir portion, and the first reservoir portion and the second reservoir portion may be integrated.

The first storage space S2 configured to accommodate the first fluid 5 may be formed in the first reservoir portion.

The second storage space S3 configured to accommodate the second fluid 6 may be formed in the second reservoir portion.

The reservoir 14 may include a hollow portion 14a having a hollow shape, a first cap 14b configured to close one end of the hollow portion 14a, and a second cap 14c configured to close the other end of the hollow portion 14a.

A first fluid passage connection portion 14d to which the first fluid passage 94 is connected, and a second fluid passage connection portion 14e to which the second fluid passage 96 is connected may be formed in the hollow portion 14a.

A through hole 14f through which a power transmission member 15b to be described later passes may be formed in one of the first cap 14b and the second cap 14c.

A reservoir sealer may be disposed between the through hole 14f and the power transmission member 15b.

In response to operation of the actuator 15, the first liquid 5 accommodated in the inner space S1 of the light-shielding cell 4 may flow to the reservoir 14, particularly to the first storage space S2.

In response to operation of the actuator 15, the second liquid 6 accommodated in the inner space S1 of the light-shielding cell 4 may flow to the reservoir 14, particularly to the second storage space S3.

The actuator 15 may oppositely increase and decrease the first storage space S2 and the second storage space S3.

As illustrated in FIG. 9 (a), the actuator 15 may decrease the first storage space S2 and may increase the second storage space S3.

As illustrated in FIG. 9 (b), the actuator 15 may increase the first storage space S2 and may decrease the second storage space S3.

The actuator 15 may include a driving source 15a, a power transmission member 15b, and a pressure plate 15c.

An example of the driving source 15a may be a motor. The driving source 15a may be a motor having a rotation shaft rotatable in both directions.

The power transmission member 15b may be operated upon driving of the driving source 15a.

An example of the power transmission member 15b may include a screw 15d rotated by the driving source 15a, and a lead nut 15e moved along the screw 15d in a longitudinal direction of the screw 15d.

The screw 15d may be directly connected to the rotation shaft of the driving source 15a or may be connected thereto by a power transmission member such as a gear.

The lead nut 15e may be provided on an outer circumference of the screw 15d.

The pressure plate 15c may partition the inside of the reservoir 14 into the first storage space S2 and the second storage space S3.

The pressure plate 15c may be disposed inside the first reservoir 14 to linearly move.

The pressure plate 15c may be connected to the power transmission member 15b. The lead nut 15e may be fastened to the pressure plate 15c, and may be moved together with the lead nut 15e.

The pressure plate 15c may selectively pressurize the first fluid 5 and the second fluid 6.

Volumes of the first storage space S2 and the second storage space S3 may be varied in response to movement of the pressure plate 15c.

When the volume of the first storage space S2 decreases, the volume of the second storage space S3 may increase.

Upon driving of the driving source 15a, as illustrated in FIG. 7a, the lead nut 15e and the pressure plate 15c may be advanced toward the first cap 14b, may compress the first storage space S2, may pressurize the first fluid 5, and may expand the second storage space S3.

The first fluid 5 accommodated in the first storage space S2 may flow to the light-shielding cell 4 and may be accommodated in the light-shielding cell 4, and the second fluid 6 accommodated in the light-shielding cell 4 may flow to the second storage space S3 and may be accommodated in the second storage space S3.

When the volume of the first storage space S2 increases, the volume of the second storage space S3 may decrease.

Upon reverse driving of the driving source 15a, as illustrated in FIG. 7b, the lead nut 15e and the pressure plate 15c may be advanced toward the second cap 14c, may expand the first storage space S2, and may compress the second storage space S3 to pressurize the second fluid 6.

The first fluid 5 accommodated in the light-shielding cell 4 may flow to the first storage space S2 and may be accommodated in the first storage space S2, and the second fluid 6 accommodated in the second storage space S3 may flow to the light-shielding cell 4 and may be accommodated in the light-shielding cell 4.

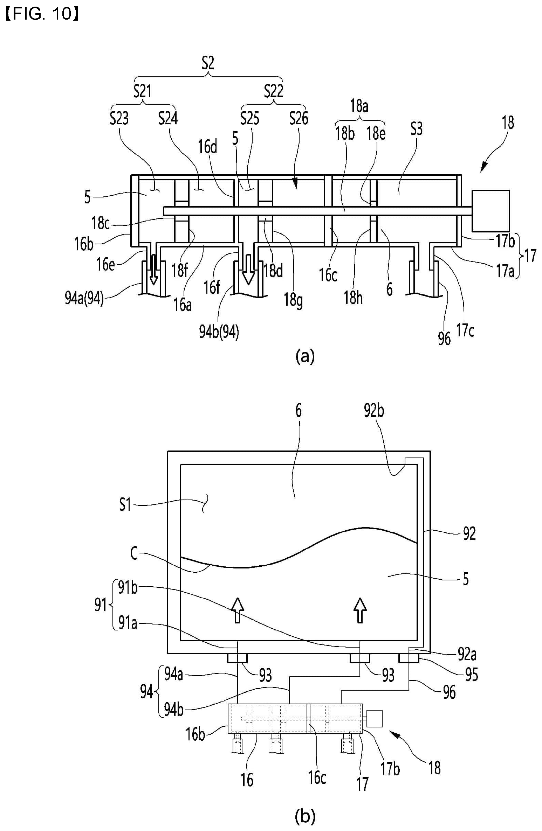

FIG. 10 illustrates a fourth example of the display device according to the present embodiment.

The fourth example of the display device may include a first reservoir 16, a second reservoir 17, and an actuator 18.

FIG. 10 (a) illustrates the first reservoir 16, the second reservoir 17, and the actuator 18 of the fourth example of the display device, and FIG. 10 (b) illustrates the light-shielding cell 4 of the fourth example of the display device.

The present embodiment may have the same or similar configuration as the first example of the display device or the third example of the display device, except for the first reservoir 16, the second reservoir 17, and the actuator 18, and the same reference numerals are used for convenience, and description thereof is omitted.

The first fluid 5 may be accommodated in the first reservoir 16, and the second fluid 6 may be accommodated in the second reservoir 17.

The first reservoir 16 may include a first hollow portion 16a having a hollow shape and a first cap 16b configured to close one end of the first hollow portion 16a.

The fourth example of the display device may include a second cap 16c configured to close the other end of the first hollow portion 16a.

The first reservoir 16 may include a barrier 16d disposed inside the first hollow portion 16a.

The barrier 16d may be disposed between the first cap 16b and the second cap 16c. The barrier 16d may be spaced apart from each of the first cap 16b and the second cap 16c.

The barrier 16d may be spaced apart from each of the first cap 16b and the second cap 16c in a longitudinal direction of the first reservoir 16.

The barrier 16d may partition an inside of the first hollow portion 16a into a first space S21 and a second space S22. The barrier 16d may partition the first storage space S2 into the first space S21 and the second space S22.

The first fluid 5 may be accommodated in the first space S21.

The first fluid 5 may be accommodated in the second space S22.

The first reservoir 16 and the second reservoir 17 may be arranged in a line.

The second reservoir 17 may be connected to the first reservoir 16. A second storage space S3 configured to accommodate the second fluid 6 may be formed inside the second reservoir 17.

The second reservoir 17 may include a second hollow portion 17a having a hollow shape. One end of the second hollow portion 17a may be closed by the second cap 16c.

The first reservoir 16 and the second reservoir 17 may share the second cap 16c. The first reservoir 16 and the second reservoir 17 may be integrated by the second cap 16c.

The other end of the second hollow portion 17a may be closed by a third cap 17b.

The second storage space S3 may be defined as a space formed between the second cap 16c and the third cap 17b.

The actuator 18 may cause the first fluid 5 and the second fluid 6 to flow.

The actuator 18 may oppositely increase and decrease the first storage space S2 and the second storage space S3.

The actuator 18 may decrease the first storage space S2 and may increase the second storage space S3.

The actuator 18 may increase the first storage space S2 and may decrease the second storage space S3.

The actuator 18 may include a driving source, a power transmission member 18a, and a plurality of pressure plates.

An example of the driving source may be a motor. The driving source may be a motor having a rotation shaft rotatable in both directions.

The power transmission member 18a may be operated upon driving of the driving source.

An example of the power transmission member 18a may include a screw 18b rotated by the driving source, and a plurality of lead nuts 18c, 18d, and 18e moved along the screw 18b in a longitudinal direction of the screw 18b.

The screw 18b may be directly connected to the rotation shaft of the driving source or may be connected thereto by a power transmission member such as a gear.

The number of lead nuts may be the same as the number of pressure plates. The lead nuts may correspond to the pressure plates on a one-to-one basis. A plurality of lead nuts may be provided on an outer circumference of the screw 18b. The plurality of lead nuts 18c, 18d, and 18e may be disposed to be spaced apart from each other.

The plurality of pressure plates may include a first pressure plate 18f, a second pressure plate 18g, and a third pressure plate 18h.

The first pressure plate 18f may be disposed inside the first reservoir 16 to linearly move.

The first pressure plate 18f may be disposed in the first space S21 formed between the first cap 16b and the barrier 16d to be linearly movable.

The first pressure plate 18f may be fastened to one 18c of the plurality of lead nuts 18c, 18d, and 18e.

The first space S21 may include a space S23 between the first cap 16b and the first pressure plate 18f, and a space S24 between the first pressure plate 18f and the barrier 16d.

Hereinafter, the space S23 between the first cap 16b and the first pressure plate 18f will be referred to as a third space S23, and the space S24 between the first pressure plate 18f and the barrier 16d will be referred to as a fourth space S24.

The first pressure plate 18f may partition the third space S23 and the fourth space S24.

The first fluid 5 may be accommodated in the third space S23. The first pressure plate 18f may pressurize the first fluid 5 in the third space S23.

The fourth space S24 may be an empty space.

The second pressure plate 18g may be disposed inside the first reservoir 16 to linearly move.

The second pressure plate 18g may be disposed in the second space S22 formed between the barrier 16d and the second cap 16c to be linearly movable. The second pressure plate 18g may be fastened to another one 18d of the plurality of lead nuts 18c, 18d, and 18e.

The second space S22 may include a space S25 between the barrier 16d and the second pressure plate 18g, and a space S26 between the second pressure plate 18g and the second cap 16c.

Hereinafter, the space between the barrier 16d and the second pressure plate 18g will be referred to as a fifth space 25, and the space S26 between the second pressure plate 18g and the second cap 16c will be referred to as a sixth space S26.

The second pressure plate 18g may partition the fifth space 25 and the sixth space S26.

The first fluid 5 may be accommodated in the fifth space S25. The second pressure plate 18g may pressurize the first fluid 5 in the fifth space S25.

The sixth space S26 may be an empty space.

The first pressure plate 18f and the second pressure plate 18g may be disposed such that a first volume of the third space S23 is different from a second volume of the fifth space S25. The first pressure plate 18f and the second pressure plate 18g may be disposed such that the first volume is greater than the second volume.

When the screw is driven in one direction, a first distance between the first cap 16b and the first pressure plate 18f may be different from a second distance between the barrier 16d and the second pressure plate 18g. The first distance may be greater than the second distance.

When the screw is driven in one direction, a pressure of the third space S23 may be different from a pressure of the fifth space S25.

One of the third space S23 and the fifth space S25 may be a high-pressure space, and the other of the third space S23 and the fifth space S25 may be a low-pressure space.

The first fluid passage 94 may include a low-pressure fluid passage 94a connected to the first space S21, and a high-pressure fluid passage 94b connected to the second space S22.

A low-pressure fluid passage connection portion 16e to which the low-pressure fluid passage 94a is connected, and a high-pressure fluid passage connection portion 16f to which the high-pressure fluid passage 94b is connected may be formed in the first hollow portion 16a of the first reservoir 16.

The low-pressure fluid passage connection portion 16e may be formed to be connected to the third space S23.

The high-pressure fluid passage connection portion 16f may be formed to be connected to the fifth space S25.

The first inlet/outlet 91 may include a low-pressure passage 91a connected to each of the inner space S1 and the low-pressure fluid passage 94a, and a high-pressure passage 91b connected to each of the inner space and the high-pressure fluid passage 94b.

The first fluid 5 accommodated in the third space S23 may pass through the low-pressure fluid passage connection portion 16e, the low-pressure fluid passage 94a, and the low-pressure passage 91a, and may then be accommodated in the inner space S1.

The first fluid 5 accommodated in the inner space S1 may pass through the low-pressure passage 91a, the low-pressure fluid passage 94a, and the low-pressure fluid passage connection portion 16e, and may then be accommodated in the third space S23.

The first fluid 5 accommodated in the fifth space S25 may pass through the high-pressure fluid passage connection portion 16f, the high-pressure fluid passage 94b, and the high-pressure passage 91b, and may then be accommodated in the inner space S1.

The first fluid 5 accommodated in the inner space S1 may pass through the high-pressure passage 91b, the high-pressure fluid passage 94b, and the high-pressure fluid passage connection portion 16f, and may then be accommodated in the fifth space S23.

Hereinafter, for convenience of description, the low-pressure fluid passage connection portion 16e, the low-pressure fluid passage 94a, and the low-pressure passage 91a will be referred to as a low-pressure flow path, and the high-pressure fluid passage connection portion 16f, the high-pressure fluid passage 94b, and the high-pressure passage 91b will be referred to as a high-pressure flow path.

The first fluid 5 accommodated in the third space S23 and the fifth space S25 may be distributed through the high-pressure flow path and the low-pressure flow path and may flow into the inner space S1, and an inflow amount supplied through the high-pressure flow path and an inflow amount supplied through the low-pressure flow path may be different from each other.

The inflow amount supplied into the inner space S1 through the high-pressure flow path may be greater than the inflow amount supplied into the inner space S1 through the low-pressure flow path, and a curved interface C as illustrated in FIG. 10b may be formed inside the inner space S1.

The curved interface may be a wave pattern, and the fourth embodiment of the display device can achieve a premium appearance.

The third pressure plate 18h may be disposed inside the second reservoir 17 to linearly move.

The third pressure plate 18h may be disposed in the second storage space S3 formed between the second cap 16c and the third cap 17b to be linearly movable. The third pressure plate 18h may be fastened to still another one 18e of the plurality of lead nuts 18c, 18d, and 18e.

The third pressure plate 18h may pressurize the second fluid 6 in the second storage space S3.

A second fluid passage connection portion 17c to which the second fluid passage 96 is connected may be formed in the second hollow portion 17a.

The second fluid passage connection portion 17c may be formed to be connected to the second storage space S3.

The second fluid 6 accommodated in the second storage space S3 may pass through the second fluid passage connection portion 17c, the second fluid passage 96, and the second inlet/outlet 92, and may then be accommodated in the inner space S1.

The second fluid 6 accommodated in the inner space S1 may pass through the second inlet/outlet 92, the second fluid passage 96, and the second fluid passage connection portion 17c, and may then be accommodated in the second storage space SS.

Hereinafter, for convenience of description, the second fluid passage connection portion 17c, the second fluid passage 96, and the second inlet/outlet 92 will be referred to as a second fluid flow path.

When the first fluid 5 flows into the inner space S1, the second fluid 6 accommodated in the inner space S1 may pass through the second fluid flow path and then flow into the second storage space S3.

When the third space S23 and the fifth space S25 are compressed, the second storage space S3 may be expanded.

When the third space S23 and the fifth space S25 are expanded, the second storage space S3 may be compressed.

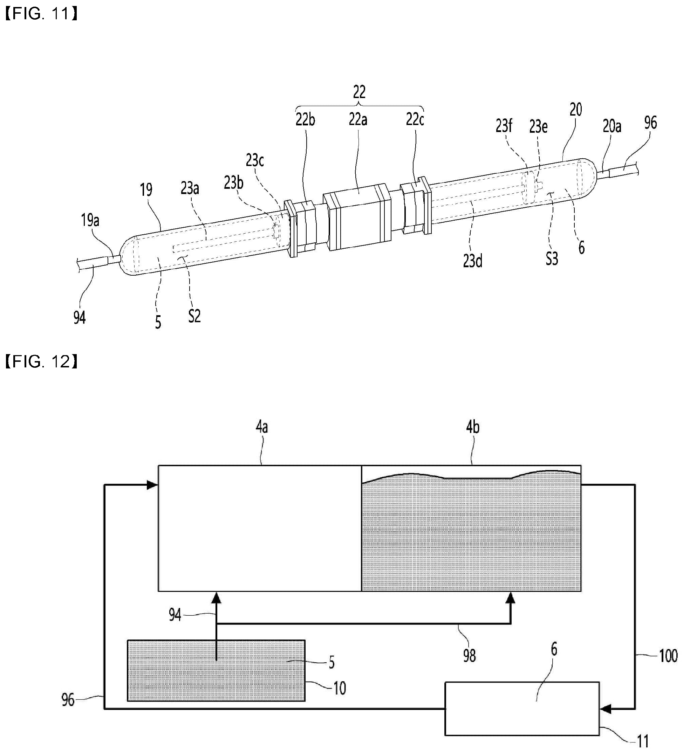

FIG. 11 illustrates a fifth example of the display device according to the present embodiment.

The fifth example of the display device may include a first reservoir 19, a second reservoir 20, and an actuator 21.

The present embodiment may have the same or similar configuration as the first example of the display device or the third example of the display device, except for the first reservoir 19, the second reservoir 20, and the actuator 21, and the same reference numerals are used for convenience, and description thereof is omitted.

A first storage space S2 configured to accommodate the first fluid 5 may be formed in the first reservoir 19. The first reservoir 19 may be a first storage tank configured to accommodate the first fluid 5.

A first fluid passage connection portion 19a to which the first fluid passage 94 is connected may be formed in the first reservoir 19. The first fluid passage connection portion 19a may communicate with the second storage space S3.

A second storage space S3 configured to accommodate the second fluid 6 may be formed in the second reservoir 20. The second reservoir 20 may be a second storage tank configured to accommodate the second fluid 6.

A second fluid passage connection portion 20a to which the second fluid passage 96 is connected may be formed in the second reservoir 20. The second fluid passage connection portion 20a may communicate with the second storage space S3.

The second reservoir 20 may be spaced apart from the first reservoir 19.

The actuator 21 may be a driving system configured to cause the first fluid 5 and the second fluid 6 to flow together.

The actuator 21 may cause the second fluid 6 corresponding to a flow rate of the first fluid 5 to flow.

The actuator 21 may oppositely increase and decrease the first storage space S2 and the second storage space S3.

The actuator 21 may decrease the first storage space S2 and may increase the second storage space S3.

When the actuator 21 is driven in one direction, the first fluid 5 stored in the first reservoir 19 may flow out of the first reservoir 19 and flow to the light-shielding cell 4, and the second fluid 6 in the light-shielding cell 4 may flow to the second reservoir 20 and may flow into the second reservoir 20.

The actuator 21 may increase the first storage space S2 and may decrease the second storage space S3.

When the actuator 21 is driven in the other direction, the first fluid 5 accommodated in the light-shielding cell 4 may flow to the first reservoir 19 and may flow into the reservoir 19, and the second fluid 6 stored in the second reservoir 20 may flow out of the second reservoir 20 and flow to the light-shielding cell 4.

The actuator 21 may simultaneously change an inflow direction and an outflow direction of the first fluid 5 and the second fluid 6 according to a driving direction.

The actuator 21 may include a driving source 22.

The driving source 22 may be disposed between the first reservoir 19 and the second reservoir 20. The first reservoir 19, the driving source 22, and the second reservoir 20 may be arranged in a line.

An example of the driving source 22 may include a motor.

The driving source 22 may include a dual-shaft motor 22a in which a first shaft protrudes toward the first reservoir 19 and a second shaft protrudes toward the second reservoir 20.

The first shaft may protrude toward the first storage space S2, and the second shaft may protrude toward the second storage space S3.

The driving source 22 may further include a first reducer 22b connected to the first shaft, and a second reducer 22c connected to the second shaft.

The first reducer 22b may be disposed between the first reservoir 19 and the dual-shaft motor 22a.

The second reducer 22c may be disposed between the second reservoir 20 and the dual-shaft motor 22a.

The actuator 21 may include a first lead screw 23a rotated by the first reducer 22b, a first lead nut 23b linearly moving along the first lead screw 23a, and a first pressure plate 23c connected to the first lead nut 23b and configured to pressurize the first fluid 5.

The first reducer 22b, the first lead screw 23a, and the first lead nut 23b may be power transmission members configured to transmit driving force of the dual-shaft motor 22a to the first pressure plate 23c.

The actuator 21 may include a second lead screw 23d rotated by the second reducer 22c, a second lead nut 23e linearly moving along the second lead screw 23d, and a second pressure plate 23f connected to the second lead nut 23e and configured to pressurize the second fluid 6.

The second reducer 22c, the second lead screw 23d, and the second lead nut 23e may be power transmission members configured to transmit driving force of the dual-shaft motor 22a to the second pressure plate 23f.

A moving direction of the first pressure plate 23c and a moving direction of the second pressure plate 23f may be the same.

When an assembly of the first reservoir 19, the second reservoir 20, and the actuator 21 is elongated in the left-right direction Y, when the first pressure plate 23c moves in the left direction, the second pressure plate 23f may move in the left direction, and when the first pressure plate 23c moves in the right direction, the second pressure plate 23f may move in the right direction.

When the first pressure plate 23c approaches the first fluid passage connection portion 19a, the second pressure plate 23f may move away from the second fluid passage connection portion 20a. Conversely, when the first pressure plate 23c moves away from the first fluid passage connection portion 19a, the second pressure plate 23f may approach the second fluid passage connection portion 20a.

Corresponding to a driving direction of the driving source 22, an inflow direction and an outflow direction of the first fluid 5 and the second fluid 6 may be simultaneously changed.

The fifth example of the display device may make a stroke of the first pressure plate 23c and a stroke of the second pressure plate 23f identical by one dual-shaft motor 22a.

In this case, a flow rate of the first fluid 5 flowing out of the first reservoir 19 may be the same as a flow rate of the second fluid 6 flowing into the second reservoir 20, and a flow rate of the first fluid 5 flowing into the first reservoir 19 may be the same as a flow rate of the second fluid 6 flowing out of the second reservoir 20.

FIG. 12 illustrates a sixth example of the display device according to the present embodiment.

The sixth example of the display device may include a plurality of light-shielding cells 4a and 4b.

Each of the plurality of light-shielding cells 4a and 4b may be the same as or similar to the light-shielding cell 4 of the first example of the display device, and description thereof is omitted to avoid duplicated description.

A pair of light-shielding cells may be provided, and the pair of light-shielding cells 4a and 4b may include a first light-shielding cell 4a and a second light-shielding cell 4b.

The sixth example of the display device may include a first transparent display facing the first light-shielding cell 4a, and a second transparent display facing the second light-shielding cell 4b.

Each of the first transparent display and the second transparent display may be the same as or similar to the transparent display 3 of the first example of the display device, and description thereof is omitted to avoid duplicated description.

The first light-shielding cell 4a may be a cluster light-shielding cell for a driver. The first light-shielding cell 4a may be the same as the light-shielding cell 4 of the first example of the display device.

The second light-shielding cell 4b may be a CID light-shielding cell installed at the center of the dashboard 2, or a PIP light-shielding cell for an occupant seated in a passenger seat.

The sixth example of the display device may include a first reservoir 10 configured to accommodate the first fluid 5, and a second reservoir 11 configured to accommodate the second fluid 6, as in the first example of the display device.

The first light-shielding cell 4a and the first reservoir 10 may be connected by a coupler and a first fluid passage 94, and the first light-shielding cell 4a and the second reservoir 11 may be connected by a coupler and a second fluid passage 96.

The second light-shielding cell 4b and the first reservoir 10 may be connected by a coupler and a third fluid passage 98, and the first light-shielding cell 4a and the second reservoir 11 may be connected by a coupler and a fourth fluid passage 100.

The first fluid passage 94 and the third fluid passage 98 may be joined/branched or may be respectively connected to the first reservoir 10.

The second fluid passage 96 and the fourth fluid passage 100 may be joined/branched or may be respectively connected to the first reservoir 10.

The present embodiment may have the same or similar configuration as the first example of the display device, except for the second light-shielding cell 4b, the third fluid passage 98, and the fourth fluid passage 100, and description thereof is omitted to avoid duplicated description.

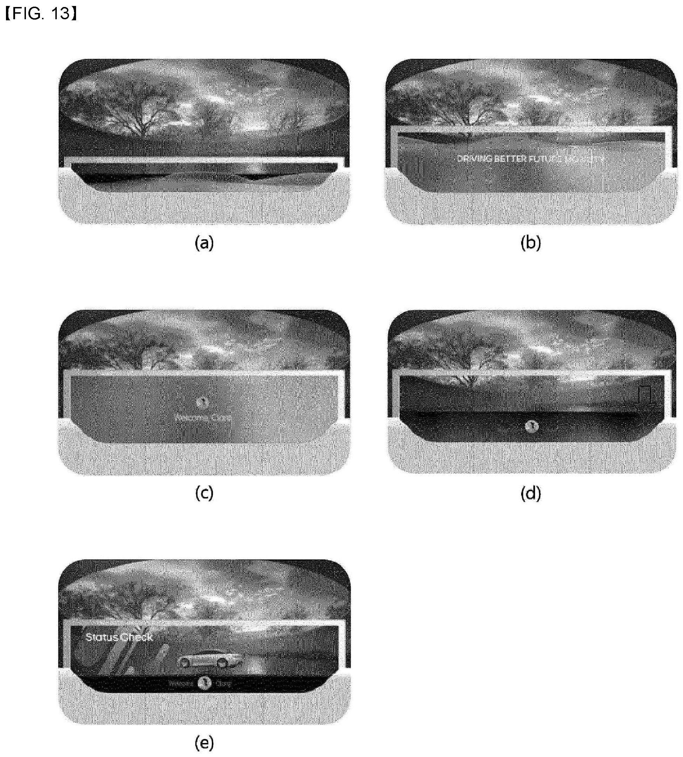

FIG. 13 illustrates one example of the display device according to the present embodiment.

FIG. 13 (a) illustrates a state in which the second fluid is accommodated in the light-shielding cell 6, FIG. 13 (b) illustrates a state in which the first fluid 5 fills a lower region of the light-shielding cell 6, and the transparent display 3 displays an initial screen in a region corresponding to the opaque region, and FIG. 13 (c) illustrates a state in which the first fluid 5 is accommodated in a lower region of the light-shielding cell 6, and the transparent display 3 displays driver information in a region corresponding to the opaque region.

When the vehicle is started and the display device is driven, the first fluid 5 fills the transparent region, and the transparent display 3 may display an initial screen as illustrated in FIG. 13 (b) and then display driver information as illustrated in FIG. 13 (c).

FIG. 13 (d) illustrates a state in which the second fluid 6 is accommodated in a lower region of the light-shielding cell 6, and FIG. 13 (e) illustrates a state in which the second fluid 6 is accommodated in the lower region of the light-shielding cell 6, and the transparent display 3 is in an AR mode.

Thereafter, the first fluid 5 in the transparent region may move downward, and the transparent display 3, as illustrated in FIG. 13 (d), may display information related to driving of the vehicle. The transparent display 3 may display a menu or the like. The transparent display 3 and the light-shielding cell 4 may be used in various modes.

When the vehicle is driven, the transparent display 3 may operate in an AR driving mode as illustrated in FIG. 13 (e).

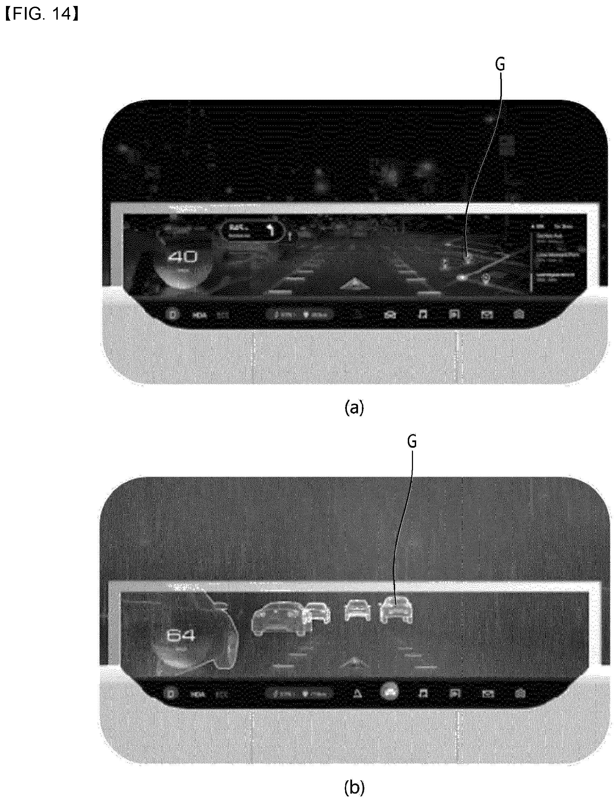

FIG. 14 illustrates a state in which the display device according to the present embodiment provides information for safe driving.

FIG. 14 (a) illustrates one example in which the display device provides information for safe driving.

When driving on a sparsely populated road without streetlights, the vehicle may obtain surrounding information through a sensor such as an Advanced Driver Assistance System (ADAS), and the transparent display 3, as illustrated in FIG. 14 (a), may display AR graphics G on the sparsely populated road without streetlights.

Even during daytime, when an obstacle is detected, the display device may display AR graphics as a notification display around the corresponding obstacle.

FIG. 14 (b) illustrates another example in which the display device provides information for safe driving.

In weather such as rain or fog, the display device may display AR graphics G on another vehicle on a road, as illustrated in FIG. 14 (b). In this case, a partial light-shielding mode may be applied to a background.

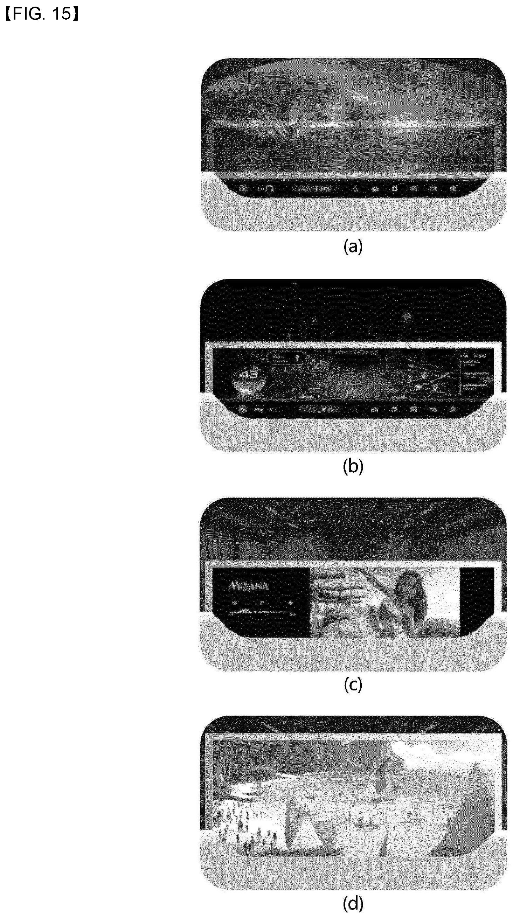

FIG. 15 illustrates an AR mode of the display device according to the present embodiment.

FIG. 15 (a) illustrates one example of the AR mode, and FIG. 15 (b) illustrates another example of the AR mode.

According to a driving situation of the vehicle, the display device may display the AR mode in a state in which the transparent region is lowered.

FIG. 15 (c) illustrates a state in which different contents are displayed for each of the transparent region and the opaque region, and FIG. 15 (d) illustrates a state in which content of the opaque region is increased and content of the transparent region is decreased.

When the vehicle is in a stopped state, a stationary state, or a limited autonomous driving mode, the display device may display content as illustrated in FIG. 15 (c) or FIG. 15 (d), and, at this time, a height of the opaque region may be adjusted.

The transparent region and the opaque region may display different contents for each region, and a size of the content may be varied depending on whether the light-shielding cell 4 is driven.

That is, when the size of the opaque region is increased, the size of the transparent region may be decreased

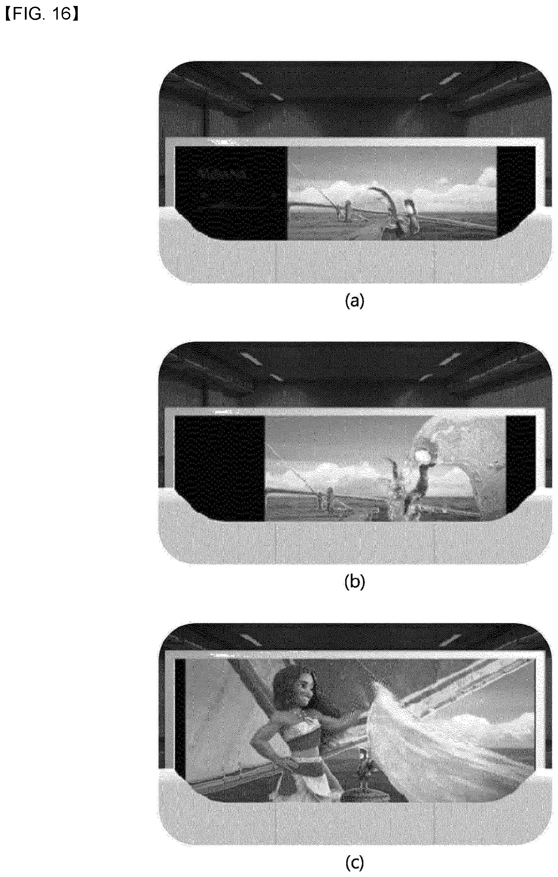

FIG. 16 illustrates a state in which an active area of the display device according to the present embodiment is changed.

FIG. 16 (a) illustrates a state in which an upper end height of the opaque region is low and a size of content is small.

FIG. 16 (b) illustrates a state in which an upper end height of the opaque region is higher than the upper end height of the opaque region illustrated in FIG. 16 (a), and a size of content is larger than the size of content illustrated in FIG. 16 (a).

FIG. 16 (c) illustrates a state in which an upper end height of the opaque region is higher than the upper end height of the opaque region illustrated in FIG. 16 (b), and a size of content is larger than the size of content illustrated in FIG. 16 (b).

The display device may expose an active region (that is, a light-shielding region or an opaque region) and may adjust a ratio of the active region to a ratio suitable for a movie, a game, or the like.

The display device may move the active region upward/downward to correspond to a ratio while content is being played.

The display device may divide and display a liquid light-shielding film on a left side, a right side, or left and right sides of the active region according to a ratio suitable for content.

Even while content is being viewed, the display device may move the active region downward based on a driving state of the vehicle, such as an increase in driving speed or a driving mode change, and may switch from the light-shielding mode to the transparent region.

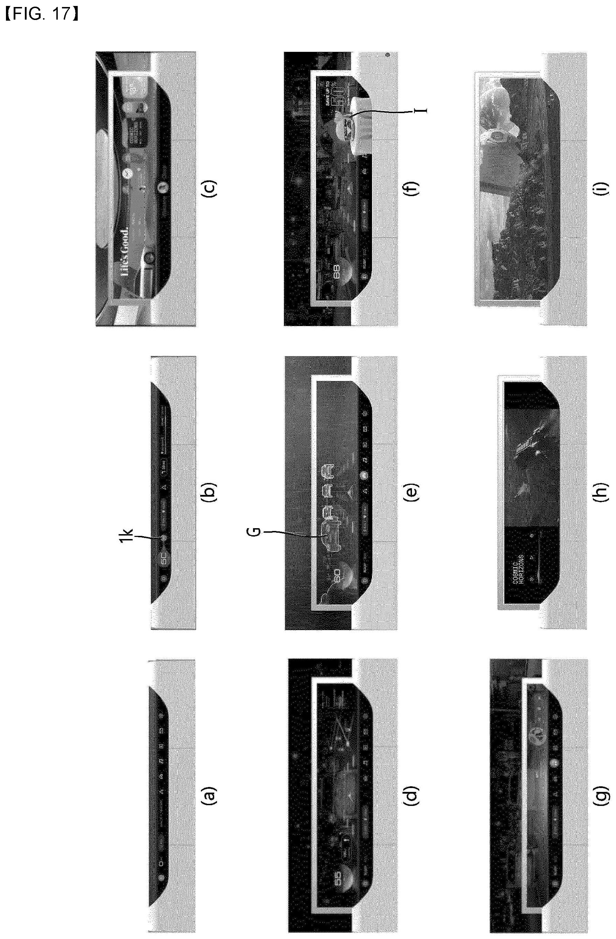

FIG. 17 illustrates an example in which the display device according to the present embodiment displays various types of information.

FIG. 17 (a) illustrates a state in which the display device is in a minimal mode, and information displayed by the display device can be minimized.

FIG. 17 (b) illustrates a state in which the display device is in the minimal mode and displays alert information (1k, Alert).

FIG. 17 (c) illustrates a state in which the display device displays a welcoming screen and displays a widget, favorites, and the like in the transparent region.

FIG. 17 (d) illustrates a state in which the display device pops up, and the transparent region overlaps with an external environment to display information in AR.

FIG. 17 (e) illustrates a state in which visibility is secured with graphics G when a front side is not clearly visible due to climate deterioration or the like.

FIG. 17 (f) illustrates a state in which event-related information I is displayed when passing a Point of Interest (POI) while driving.

FIG. 17 (g) illustrates a state in which related information is displayed by utilizing the transparent region when listening to music while driving.

FIG. 17 (h) illustrates a state in which various contents such as a movie are displayed when stopped.

FIG. 17 (j) illustrates a state in which the display device pops up to a maximum height and displays an image on a full screen.

The above description is merely an illustrative explanation of the technical idea of the present disclosure, and various modifications and variations will be possible to those skilled in the art without departing from the essential characteristics of the present disclosure.

Accordingly, the embodiments disclosed in the present disclosure are not intended to limit the technical idea of the present disclosure, but are for illustrative purposes, and the scope of the technical idea of the present disclosure is not limited by these embodiments.

The scope of protection of the present disclosure should be interpreted in accordance with the claims below, and all technical ideas within the equivalent scope should be interpreted as being comprised in the scope of rights of the present disclosure.

## Claims

1. A display device, comprising:
a transparent display;
a front glass facing the transparent display;
a rear glass facing the front glass; and
a sealing member disposed between the front gla and the rear glass,
wherein an inner space configured to accommodate at least one of a first fluid and a second fluid is formed the front glass and the rear glass,
wherein a specific gravity of the first fluid is different from a specific gravity of the second fluid,
wherein a first inlet/outlet through which the first fluid flows into the inner space or through which the first fluid in the inner space flows out is formed in a portion of the sealing member, and
wherein a second inlet/outlet through which the second fluid flows into the inner space or through which the second fluid in the inner space flows out is formed in another portion of the sealing member.

2. The display device according to claim 1, further comprising:
a bezel configured to fix the front glass and the rear glass,
wherein an area of the bezel is greater than a projected area of the sealing member.

3. The display device according to claim 1, further comprising:
a curing agent formed on one side of the sealing member.

4. The display device according to claim 1,
wherein the front glass comprises:
a first surface adjacent to the transparent display; and
a second surface opposite to the first surface,
wherein the rear glass comprises:
a third surface adjacent to the second surface; and
a fourth surface opposite to the third surface,
wherein a front water-repellent layer is formed on the second surface, and
wherein a rear water-repellent layer is formed on the third surface.

5. The display device according to claim 1, further comprising:
a first reservoir configured to accommodate the first fluid;
a second reservoir configured to accommodate the second fluid;
a first fluid passage disposed between the first reservoir and the first inlet/outlet; and
a second fluid passage disposed between the second reservoir and the second inlet/outlet,
wherein the first fluid passage is connected to each of the inner space and the first reservoir, and
wherein the second fluid passage is connected to each of the inner space and the second reservoir.

6. The display device according to claim 5,
wherein a plurality of first fluid passages are provided,
wherein a plurality of first inlet/outlets are provided to correspond to the plurality of first fluid passages,
wherein a plurality of second fluid passages are provided, and
wherein a plurality of second inlet/outlets are provided to correspond to the plurality of second fluid passages.

7. The display device according to claim 6,
wherein the first fluid accommodated in the first reservoir is branched into the plurality of first fluid passages and moves into the inner space through the plurality of first fluid passages, and
wherein the second fluid accommodated in the second reservoir is branched into the plurality of second fluid passages and moves into the inner space through the plurality of second fluid passages.

8. The display device according to claim 5,
wherein a plurality of first reservoirs and a plurality of first fluid passages are provided, and
wherein a plurality of second reservoirs and a plurality of second fluid passages are provided.

9. The display device according to claim 5,
wherein, among the first fluid and the second fluid, a fluid having a higher specific gravity flows into the inner space through a lower portion of the inner space or flows out through the lower portion of the inner space, and
wherein, among the first fluid and the second fluid, a fluid having a lower specific gravity flows into the inner space through an upper portion of the inner space or flows out through the upper portion of the inner space.

10. The display device according to claim 5,
wherein, when the first fluid accommodated in the first reservoir flows into the inner space through the first fluid passage and the first inlet/outlet, the second fluid accommodated in the inner space moves to the second reservoir through the second inlet/outlet and the second fluid passage.

11. The display device according to claim 5,
wherein at least one of the first reservoir and the second reservoir is disposed below the transparent display.

12. The display device according to claim 1, comprising:
a variable reservoir configured to accommodate one of the first fluid and the second fluid and having a variable internal volume; and
an actuator configured to pressurize the variable reservoir,
wherein, in response to operation of the actuator, the fluid in the variable reservoir moves into the inner space.

13. The display device according to claim 1, comprising:
a reservoir in which a first storage space configured to accommodate the first fluid and a second storage space configured to accommodate the second fluid are formed; and
an actuator configured to increase one of the first storage space and the second storage space while decreasing the other of the first storage space and the second storage space,
wherein the actuator comprises:
a driving source;
at least one power transmission member operated upon driving of the driving source; and
a pressure plate configured to partition an interior of the reservoir into the first storage space and the second storage space and connected to the at least one power transmission member.

14. The display device according to claim 13,
wherein volumes of the first storage space and the second storage space are varied in response to movement of the pressure plate,
wherein, when the volume of the first storage space decreases, the volume of the second storage space increases, and
wherein, when the volume of the first storage space increases, the volume of the second storage space decreases.

15. The display device according to claim 1, comprising:
a first reservoir in which a first storage space configured to accommodate the first fluid is formed; and
a second reservoir in which a second storage space configured to accommodate the second fluid is formed,
wherein the first reservoir comprises a barrier configured to partition the first storage space into a first space configured to accommodate the first fluid and a second space configured to accommodate the first fluid,
wherein the first fluid passage comprises:
a low-pressure passage connected to each of the inner space and the first space; and
a high-pressure passage connected to each of the inner space and the second space.

16. The display device according to claim 1, comprising:
a first reservoir configured to accommodate the first fluid;
a second reservoir configured to accommodate the second fluid and spaced apart from the first reservoir; and
a driving source disposed between the first reservoir and the second reservoir,
wherein the first reservoir, the driving source, and the second reservoir are arranged in a line.

17. The display device according to claim 16,
wherein, corresponding to a driving direction of the driving source, an inflow direction and an outflow direction of the first fluid and an inflow direction and an outflow direction of the second fluid are simultaneously changed.
